# EUROPEAN PATENT APPLICATION

(11) **EP 4 644 755 A1**
(43) Date of publication of application: **05.11.2025**
(21) Application number: 24186876.9
(22) Date of filing: 05.07.2024
(51) Int. Cl.: F16L 21/025, F16L 21/035, G06F 1/20, H05K 7/20

(54) **O-RING GLAND FITTINGS FOR LIQUID COOLING WITH O-RING COMPRESSION SEAL HAVING REDUNDANT NON-RADIAL SEAL PAIRS**

(30) Priority: 29.04.2024 US 202418649392
(71) Applicant: Hewlett Packard Enterprise Development LP, Spring, TX 77389 (US)
(72) Inventor: DEAN, Steven J, Chippewa Falls, 54729 (US)
(74) Representative: Marks & Clerk LLP

(57) **Abstract**

An O-ring gland fitting for a liquid cooling loop of an information processing device comprises a plug (201), a socket (202), and an O-ring (280). The plug comprises a mating protrusion (210) and a plug gland surface (223). The socket comprises a socket gland surface (244) and a mating recess (241) configured to receive the mating protrusion (210) in a mated state of the plug and socket. The plug and socket gland surface are configured to, in the mated state, form a gland which contains the O-ring. The plug and socket gland surface comprises complementary sealing surface features configured to, in the mated state, compress the O-ring therebetween and form multiple non-radial seal pairs, each of which comprises two contact-stress surface-seals on opposite non-radial sides of the O-ring.

## Description

### INTRODUCTION

Information processing devices, such as computers and networking devices, generate heat when in use. Cooling systems may be utilized to remove heat from components of the information processing devices to keep them within desired operating temperatures. In some cases, the cooling system may be a liquid cooling system which flows liquid coolant through a liquid cooling loop to remove heat from one or more information processing devices. The liquid cooling system may include various components of liquid cooling infrastructure, such as tubes/pipes, manifolds, fittings, cold plates, pumps, heat exchanger, etc.

Fittings for a liquid cooling system (also referred to as couplings, fluid couplings, hose couplings, etc.) may be used to connect two liquid cooling components, such as two tubes/pipes, together in a manner which allows for liquid to flow therebetween. Some fittings are permanent fittings, which are generally difficult to decouple after having been coupled together. Examples of such permanent fittings include brazed/soldered pipe fittings and hose-barb/clamp fittings. Other fittings are removable fittings, which are generally designed to be more easily coupled and decoupled. Examples of such removable fittings include fluid quick-disconnect (QD) fittings and fluid O-ring gland fittings. Removable fittings generally comprise two parts configured to work as a mating pair, with each part of the fitting having one end which is more permanently connected to another liquid cooling component (e.g., a pipe) and another end configured to be removably mated with the other part of the fitting. Often, one part of the fitting has an axially recessed mating portion configured to receive an axially protruding mating portion of the other part inserted therein. The part of the fitting which receives the other may be referred to herein as the "socket" and the part of the fitting which is inserted into the other may be referred to herein as the "plug."

A QD fitting is designed to allow easy decoupling, often without requiring the use of tools. To allow for this, a QD fitting may have latching mechanisms to secure the fittings together while allowing an easy (often toolless) release. There are also often moving parts such as a poppet or check valve, to provide automatic closing during coupling/decoupling. In addition, there may be multiple sealing surfaces to seal different parts relative to one another. Thus, QD fittings can be relatively complicated, with many intricate mechanical structures.

In contrast, fluid O-ring gland fittings tend to be simpler than QD fittings. Generally, the mating protrusion of the plug is inserted into the recessed portion of the socket, and an O-ring is provided encircling the mating protrusion which is compressed between the plug and socket to seal the interface therebetween and prevent leaks.

### BRIEF DESCRIPTION OF THE DRAWINGS

The present disclosure can be understood from the following detailed description, either alone or together with the accompanying drawings. The drawings are included to provide a further understanding of the present disclosure and are incorporated in and constitute a part of this specification. The drawings illustrate one or more examples of the present teachings and together with the description explain certain principles and operations. In the drawings:
FIG. 1 is a block diagram illustrating an example liquid cooling fitting.
FIG. 2 is a cross-section of another example liquid cooling fitting with plug and socket in a non-mated state and with O-ring omitted from view.
FIG. 3 is a cross-section of the liquid cooling fitting of FIG. 2 with plug and socket in the non-mated state.
FIG. 4 is a cross-section of the liquid cooling fitting of FIG. 2 with plug and socket in a mated state and with O-ring omitted from view.
FIG. 5 is a cross-section of the liquid cooling fitting of FIG. 2 with plug and socket in the mated state.
FIG. 6 is an enlarged view of a portion of the liquid cooling fitting of FIG. 2 in the mated state.
FIG. 7A is another enlarged view of the portion of the liquid cooling fitting of FIG. 2 in the mated state with the O-ring in a swollen state.
FIG. 7B is another enlarged view of the portion of the liquid cooling fitting of FIG. 2 in the mated state with an enlarged gland due to tolerances.
FIG. 7C is another enlarged view of the portion of the liquid cooling fitting of FIG. 2 in the mated state with an enlarged gland due to a gap between socket and plug.

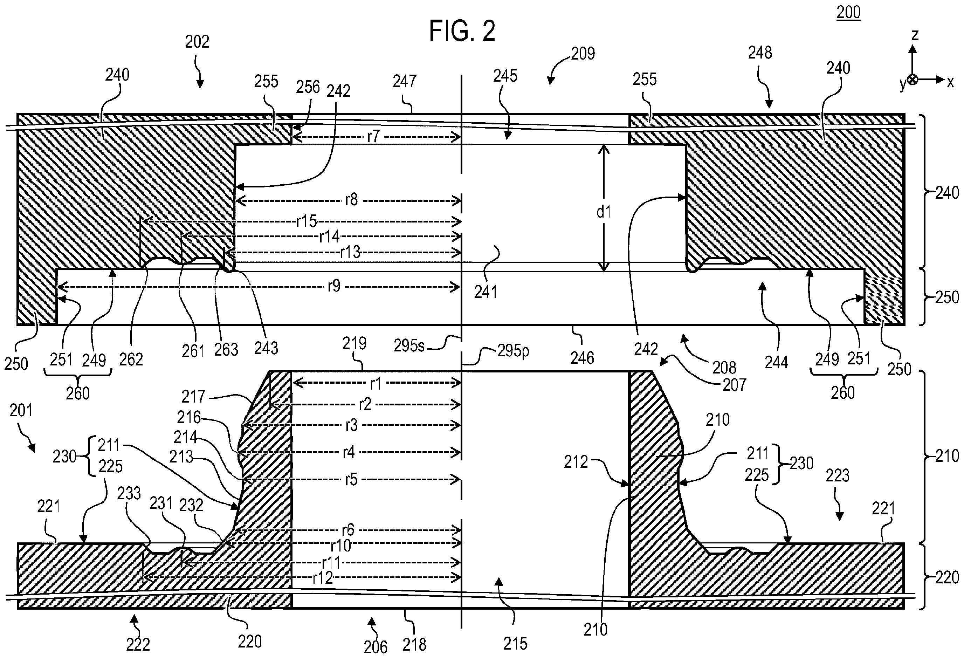

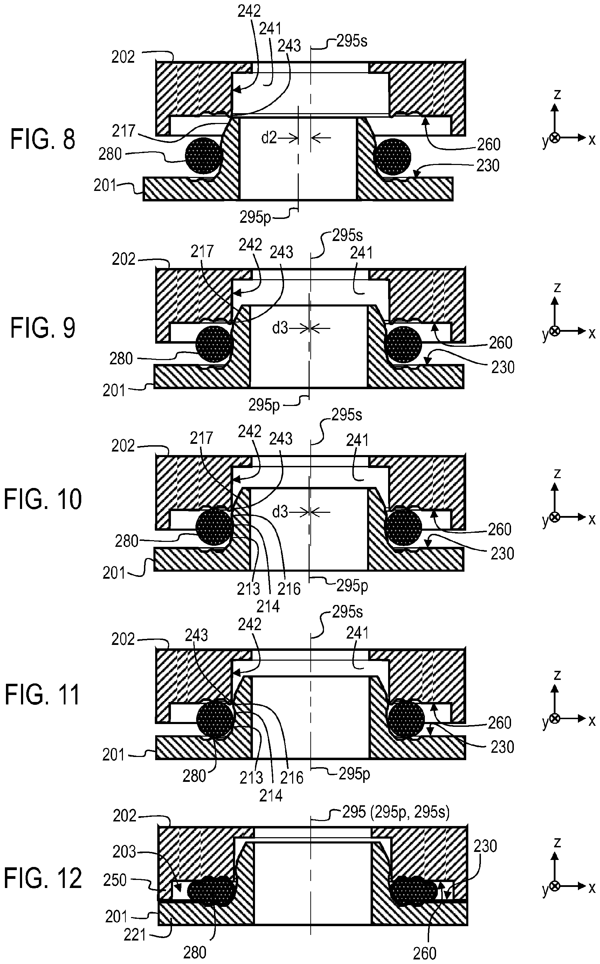

FIGs. 8-12 comprise cross-sections depicting a mating sequence of the liquid cooling fitting of FIG. 2. FIG. 8 is a cross-section of the liquid cooling fitting in a first stage of the mating sequence. FIG. 9 is a cross-section of the liquid cooling fitting 2 in a second stage of the mating sequence. FIG. 10 is a cross-section of the liquid cooling fitting in a third stage of the mating sequence. FIG. 11 is a cross-section of the liquid cooling fitting in a fourth stage of the mating sequence. FIG. 12 is a cross-section of the liquid cooling fitting in a fifth stage of the mating sequence corresponding to the mated state.
FIG. 13 is a perspective view of a plug of the fitting of FIG. 2.
FIG. 14 is a perspective view of a socket of the fitting of FIG. 2.
FIG. 15 is a schematic diagram of an example information processing system comprising a liquid cooling loop with one or more liquid cooling fittings.

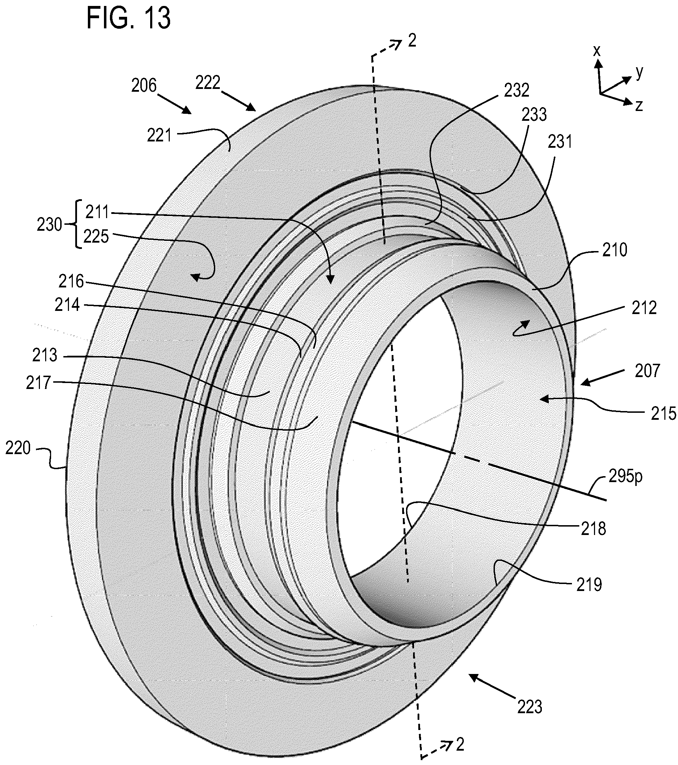

In each of the sectional views, the section is taken along (i.e., the cutting plane extends along) a plane parallel to a central axis 295 of the fitting, which is indicated by line 2-2 in FIGs. 12 and 13. Cut surfaces are depicted by hatching.

### DETAILED DESCRIPTION

Permanent fittings often establish a reliable leak-free connection. However, these permanent fittings may not be suitable for use in all fluid connections. For example, at connections where it is desired to allow for easy decoupling of the fitting in the future, a permanent fitting may not be suitable. Examples of such connections where easy decoupling may be desired include the connection between an information processing device and a fluid supply line or fluid return line, as the information processing device may need to be occasionally removed from the larger system in which it is installed (e.g., system enclosure or rack/cabinet), for example for maintenance, service, replacement, etc. Thus, a removable fitting may be better suited for use in such instances.

QD fittings could be used to establish such removable connections. However, QD fittings can be relatively complicated mechanical, and thus can be relatively expensive. Moreover, all the intricate and movable parts in a QD fitting can provide additional opportunities for failure, and QD fittings tend to have a non-negligible risk of leakage. In the context of some information processing systems, which may have sensitive and expansive equipment, such a risk of leakage may make the QD fittings a less desirable choice.

To avoid the cost and failure risk of QD fittings, it may be desired in some contexts to instead use fluid O-ring gland fittings to establish the removable connection. However, it can be challenging to produce a fluid O-ring gland fitting with an O-ring seal which can sufficiently ensure leak free operation in the context of liquid cooling a computing system, given certain challenges which are specific to this context. In particular, existing fitting and O-ring designs, which may suffice in other contexts, generally fail to meet the requirements of liquid cooling certain computing systems.

In one common O-ring arrangement, when the two parts of the fitting are mated, the O-ring is situated between a radially outer surface of the mating protrusion of the plug and a radially inner surface of the socket, with the plug contacting a radially inward side of the O-ring and the socket contacting a radially outward side of the O-ring. (Radial refers to any direction perpendicular to an axis of the fitting part, wherein the axis extends along the channel thereof). The O-ring is squeezed (deformed) radially between the plug and socket, creating two contact-stress surface-seals on opposite sides of the O-ring (a radially outer side and a radially inner side). These contact-stress surface-seals are referred to as radial seals because the seals occur at radial portions of the O-ring, i.e., portions which are intersected by radial rays originating from a center point of the O-ring. In other words, in a cross section, a direction perpendicular to the surface of the O-ring at the seal (the normal vector) points radially outward or radially inward. A seal pair may comprise two seals which, in a cross section, are disposed on diametrically opposite sides of the O-ring from one another and which are formed by compression of the O-ring along a line extending between the two seals. In the arrangement described above, the two radial contact-stress surface-seals together form a radial seal pair with the line of compression extending in a radial direction (i.e., the O-ring is compressed radially).

This radial seal arrangement is commonly used for its simplicity in manufacture and ease of use. However, radial seal O-ring arrangements can, under some circumstances, be prone to leakage. One reason for this is that, due to the way O-rings are manufactured, they usually have small imperfections called "flash" which encircle the O-ring along the outer radial surface thereof and along the inner radial surface thereof. This flash is generally shaped like a small ring-like flange or ridge protruding radially from the O-ring and running circumferentially around the O-ring-an outer flash will protrude radially outward around the outer circumference of the O-ring, while an inner flash will protrude radially inward around the inner circumference of the O-ring. Because this flash is located on the outer radial surface and on the inner radial surface, it is located where the contact seals are to be formed in a standard radial seal. The presence of the flash at the sealing interface can prevent perfectly smooth and flush contact between the sealing surfaces, and thus the flash can reduce the effectiveness of the seal, potentially leading to leaks. Often, O-rings are processed post-manufacture in an attempt to remove the flash. This may be done, for example, by buffing, sanding, flash freezing, or tumbling. However, flash removal techniques may not be perfect, and in many cases some small residual part of the flash and/or other surface imperfections will remain after the flash removal process. Thus, even after a flash removal process, there remains a risk of leaks developing through the radial seal. Such leaks may be tolerable in some contexts where the leak is unlikely to do damage or where the damage would not be very costly. However, they are generally not tolerable in the context of computing systems which comprise sensitive and expensive electronic equipment-in some cases, hundreds of thousands of dollars' worth of equipment or more in large High Performance Compute (HPC) or Supercomputer systems-where even a small leak could cause damage and the damage is likely to be costly. Accordingly, fittings with the common radially sealing O-ring design may not be suitable for many computing systems.

One way to try to mitigate the risk of leaks through a radial sealing O-ring is to provide multiple O-rings in the same fitting. This can reduce the risk of a leak because the leak would have to pass through two O-rings concurrently. However, in order to accommodate multiple O-rings in the same fitting, the size of the fitting may need to be increased, which is disadvantageous in some space constrained computing systems. The larger fittings with extra O-rings may also cost more. Moreover, while providing multiple O-rings may help reduce the risk of leaks somewhat, the risk is generally not reduced sufficiently for the needs of liquid cooling certain computing systems. Both of the O-rings still suffer from the same defects noted above (e.g., sealing on the flash), and thus there remains a non-negligible risk of a leak developing through both of the O-rings concurrently. Accordingly, using multiple O-rings per fitting is unlikely to make the fitting suitable for use in some computing systems.

There are some hydraulic or pneumatic fitting designs which can provide good leak resistance. However, these hydraulic or pneumatic fittings are generally designed to be used in systems with relatively high-pressure fluids, such as between 150-1000+ PSI. Such fittings and their O-rings tend to rely on the pressure of the fluid itself to "activate" the O-ring, meaning to move the O-ring from a resting position into a sealing position and deform the O-ring to help establish the seal. Counterintuitively, these types of high-pressure fittings are generally prone to leaking when used in contexts with lower fluid pressures because the lower fluid pressures are not able to properly activate the O-ring. Thus, existing hydraulic or pneumatic fitting designs may not be suitable for use in some computing systems where lower pressures are used, such as around 30 PSI Gauge ± 20 PSI, as the fittings are likely to leak at these low pressures due to failure to properly activate the O-ring.

On the other hand, there are fittings with O-rings designed to work in systems with extremely low pressures, such as near vacuum. However, to achieve a suitable seal at such low pressures, these fittings generally require the use of a vacuum grease which is applied around the O-ring. The grease fills in the small gaps and surface imperfections, helping to prevent leaks. But such grease may not be suitable for use in some computing systems with liquid cooling, where the presence of grease could contaminate the liquid coolant and/or potentially degrade its performance.

Accordingly, it is difficult to find or produce a compact, cost effective, removable fitting with an O-ring seal which can provide reliable sealing with extremely low risk of leaks while operating at low fluid pressures and without the need for grease or other seal-assist agents.

To address the issues described above, examples disclosed herein provide fluid O-ring gland fittings which have a new type of O-ring seal arrangement in which the two parts of the fitting compress an O-ring in a way that forms multiple non-radial seal pairs. As noted above, a seal pair comprises two contact-stress surface-seals which are, in a cross-section, disposed on diametrically opposite sides of the O-ring, with a compression line extending therebetween. In the non-radial seal pairs formed by example fittings disclosed herein, the compression line extends along a non-radial direction, such as along an axial direction (in a type of seal referred to herein as a face seal) or along a direction partway between the axial and radial directions (in type of seal referred to herein as an angular seal). In examples disclosed herein, at least two different non-radial seal pairs are formed, such as a face seal pair and an angular seal pair in one example, two different angular seal pairs in another example, a face seal pair and two different angular seal pairs in another example, or any other combination of two or more different non-radial seal pairs.

Because these non-radial seal pairs are non-radial, the seals are formed by portions of the O-ring surface that do not have any flash (i.e., non-radial portions), and therefore the flash will not interfere with the sealing ability of the non-radial seal pairs. Thus, the non-radial seal pairs are much less likely to leak than a standard radial seal.

In addition, because there are multiple different non-radial seal pairs, redundancy is provided so that, even if one seal pair fails, the other seal pair(s) may be able to contain the leak. In other words, multiple seals would have to fail concurrently before a leak could develop, and thus the chances of a leak developing are reduced as compared to a seal which relies on a single seal pair. Furthermore, examples disclosed herein may provide this redundancy in just a single O-ring, which can allow the fittings disclosed herein to be smaller and less expensive than other fittings which might seek to achieve sealing redundancy through the use of multiple O-rings.

In fittings disclosed herein, the socket and plug comprise respective gland surfaces which engage opposite sides of the O-ring to create the non-radial seal pairs. These gland surfaces together define a gland therebetween when the couplings are mated, with the O-ring being contained within the gland. The gland surfaces include multiple surface features which cooperate to form the above-noted non-radial seal pairs. In particular, each non-radial seal pair is formed by a pair of opposing surface features in the gland surfaces, with one surface feature of the pair being part of the gland surface of the plug and the other surface feature of the pair being part of the gland surface of the socket. A pair of surface features is configured to contact and compress the O-ring therebetween during mating such that, in a cross-section, the compression occurs along a compression line extending between the two surface features, with the compression line extending along a non-radial direction. For example, a pair of surface features that forms a face seal may be disposed opposite from one another along an axial direction such that, in a cross-section, the compression line extending therebetween extends axially (parallel to an axis of the fitting). As another example, a pair of surface features that form an angular seal may be disposed diagonally opposite one another such that, in a cross-section, the compression line extends at a non-zero and non-right angle (e.g., a 45° angle) relative to the axis of the fitting.

In some examples, the surface features of the gland surfaces which form the non-radial seal pairs are configured to form regions of relatively high contact stress in the O-ring when the plug and socket are mated, with these regions of high contact stress forming the contact-stress surface-seals of the non-radial seal pairs. The regions of high contact stress may have a contact pressure (contact stress per unit area) which is greater than the liquid's pressure, thus forming a seal which prevents the liquid from pushing between the O-ring and the surface feature. For example, the surface features may comprise protrusions (e.g., ridges), corners (e.g., radiused, chamfered, right-angled), sloped sections, or other surface features of the gland surface which are arranged so as contact and compress a portion of the O-ring during mating. These surface features allow the plug and socket to activate the O-ring on their own without relying on the pressure of the liquid to do so, in contrast to high-pressure pneumatic or hydraulic fittings. That is, the surface features may be arranged to engage with the O-ring during matting, move the O-ring to its sealing position, and compress and deform the O-ring therebetween, without relying on the liquid pressure to achieve these.

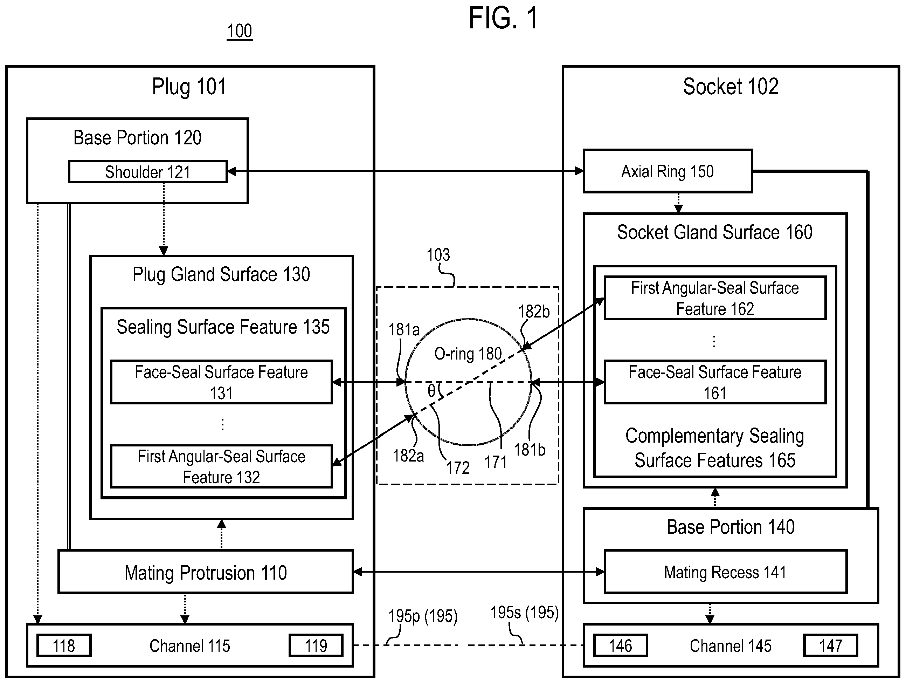

These and other aspects of examples disclosed herein will be described in greater detail below in relation to FIGs. 1-15.

FIG. 1 illustrates an example liquid cooling fluid O-ring gland fitting 100 (fitting 100). FIG. 1 is schematic in nature and is not intended to illustrate shapes, sizes, or other structural details accurately or to scale. Some examples of the fitting 100 may include components which are not illustrated in FIG. 1, and one or more components illustrated in FIG. 1 may be omitted from the fitting 100 in some examples. In FIG. 1, physical connections between components are indicated conceptually by double solid lines; engagements between components are indicated conceptually by solid lines with arrows; other relationships between components (such as one component being formed in and/or defined by one or more other components) are indicated by dotted lines; and directions or axes are indicated by dashed lines.

As shown in FIG. 1, the fitting 100 comprises a plug 101, a socket 102, and an O-ring 180. The plug 101 is configured to removably mate with the socket 102, with the O-ring 180 being disposed therebetween to form a liquid tight seal. The fitting 100 may be used, for example, in a liquid cooling loop for cooling an information processing device. For example, the plug 101 may be connected to a first liquid cooling component (e.g., a pipe, a pump, a manifold, etc.), the socket 102 may be connected to a second liquid cooling component (e.g., a pipe, a pump, a manifold, etc.), and then when the plug 101 and socket 102 are mated together this creates a fluid connection between the two liquid cooling components.

Specifically, the plug 101 comprises a base portion 120 having a first side configured to be connected to a first liquid cooling component and a mating protrusion 110 which protrudes axial from a second side of the base portion 120. In some examples, the first side of the base portion 120 may be connected to the first liquid cooling component via a permanent or semi-permanent connection, such as a soldered/brazed connection, a threaded connection, a hose-barb connection, a compression fitting style connection, a push-to-connect (e.g., SharkBite) fitting style connection, a Yor-Lok fitting style connection, etc. Thus, the first side of base portion 120 may include connection features to facilitate such a connection. Such connections would be familiar to those of ordinary skill in the art, and thus are not illustrated or described in greater detail herein. In other examples, the base portion 120 may be an integrally connected part of (formed as part of a same monolithic body as) the first liquid cooling component-for example, the base portion 120 may be an integral part of a housing of a pump or manifold. The plug 101 also has a channel 115 extending therethrough along an axis 195p, with the channel 115 forming the liquid flow path through the plug 101. The channel 115 extends along an axis 195p through both the base portion 120 and the mating protrusion 110, with radially inward facing surfaces of the base portion 120 and mating protrusion 110 defining circumferential bounds of the channel 115. The channel 115 has two openings at opposite ends thereof, with a first opening 118 being located in the base portion 120 at a first end of the plug 101 and a second opening 119 being located in a distal end of the mating protrusion 110 at a second end of the plug 101 opposite the first end. The channel 115 is fluidically coupled to the first liquid cooling component via the first opening 118 when the component is coupled to the base portion 120 (e.g., the first component may be inserted into the channel 115 via the first opening 118, the first opening 118 may be inserted into a channel of the first component, or the first opening 118 and the first component may be coupled via another part such as an adapter or permanent fitting).

The socket 102 comprises a base portion 140 having a first side comprising a mating recess 141 configured to removably receive the mating protrusion 110 in the mated state of the plug 101 and socket 102 and a second side configured to be connected to a second liquid cooling component. In some examples, the second side of the base portion 140 may be connected to the second liquid cooling component via a permanent or semi-permanent connection and thus may include connection features to facilitate such as connection, which are familiar to those in the art and not illustrated herein. In other examples, the base portion 140 may be an integrally connected part of the second liquid cooling component. The base portion 140 also comprises a channel 145 extending therethrough along an axis 195s. The mating recess 141 is recessed axially from a first axial face of the base portion 140 at the first side thereof and includes a portion of the channel 145. In other words, radially inward facing surfaces of the base portion 140 define circumferential bounds of the channel 145, and a portion of these surfaces also form the mating recess 141. The channel 145 comprises two openings at opposite ends thereof, with a first opening 146 being located in the base portion 140 (in the mating recess 141) at a first end of the socket 102 and a second opening 147 in the base portion 140 at a second end of the socket 102 opposite the first end. The channel 145 is fluidically coupled to the second liquid cooling component via the first opening 146 when the component is coupled to the base portion 140 (e.g., the second component may be inserted into the channel 145 via the first opening 146, the first opening 146 may be inserted into a channel of the second component, or the first opening 146 and the second component may be coupled via another part such as an adapter or permanent fitting).

When the plug 101 and socket 102 are mated, the mating protrusion 110 is inserted through the first opening 146 into the mating recess 141, such that the second opening 119 is contained within and fluidically coupled to the channel 145. Thus, in the mated state, the channels 115 and 145 are fluidically coupled together and thus liquid can flow from the channel 115 into the channel 145, or vice versa. In addition, in the mated state, the axes 195p and 195s may be substantially aligned with one another (i.e., coaxial), and thus in this state the axes 195p and 195s may be referred to individually or collectively as an axis 195 of the fitting 100.

The mating protrusion 110 of the plug 101 may have any desired shape. For example, the mating protrusion 110 may have, in some implementations, the general shape of a right circular hollow cylinder (i.e., a cylindrical shell or pipe-like shape), with or without tapering towards a distal end and/or lead-in features at the distal end (e.g., rounded or chamfered edges). The mating recess 141 of the socket 102 may have a shape which is complementary to that of the mating protrusion 110 so that the mating recess 141 can receive the mating protrusion 110 therein. For example, the mating recess 141 may comprise a cylindrical bore having a diameter approximately equal to (e.g., just slightly larger than) the outer diameter of the mating protrusion 110.

The plug 101 and socket 102 comprise a plug gland surface 130 and a socket gland surface 160, respectively. When the plug 101 and socket 102 are mated, these gland surfaces 130, 160 are disposed opposite one another and cooperate to define a gland 103 therebetween. The gland 103 is a volume between the mated plug 101 and socket 102 in which the O-ring 180 is disposed.

The plug gland surface 130 is defined in part by the base portion 120 and in part by the mating protrusion 110. Specifically, in some examples the base portion 120 protrudes radially outward from the mating protrusion 110, with the base portion having an axial face which faces in a generally axial direction towards the socket 102. The axial face of the base portion 120, together with part of the outer radial surface of the mating protrusion 110, form the plug gland surface 130.

The socket gland surface 160 is defined, at least in part, by the first axial face of the base portion 140, which as mentioned above is the face from which the mating recess 141 is recessed. This first axial face is also the face of the base portion 140 which faces the base portion 120 of the plug 101 when mated.

As the plug 101 and socket 102 are mated together, the gland surfaces 130 and 160 move axially towards one another. The gland surfaces 130 and 160 define a volume therebetween in which the O-ring 280 is contained, with that volume being referred to herein as a gland 103. Note that the gland 203 is not necessarily a fully closed or sealed volume, but rather corresponds to the space generally between the gland surfaces 130 and 160. Eventually, the gland surfaces 130 and 160 are close enough to one another that they contact and begin to compress the O-ring 180 therebetween. Further movement of the gland surfaces 130 and 160 closer together further compresses the O-ring, until, in the fully mated position, the O-ring is compressed sufficiently to form a plurality of different non-radial seal pairs, as will be described below.

In some examples, the fitting 100 comprises an axial ring 150 and a shoulder 121, and the axial ring 150 and shoulder 121 may also form portions of the plug and socket gland surfaces 130 and 160. The axial ring 150 may have the general shape of a ring (a rectangular toroid) with its central axis aligned with the axis 195a, and the axial ring 150 may protrude in an axial direction from either the base portion 120 or the base portion 140. The shoulder 121 may be an axially facing surface which is disposed opposite from the axial ring 150 in the mated state. In the mated state, the axial ring defines a radial bound of the gland 203. In some examples, the shoulder 121 may contact the axial ring 150 in the mated state. In other cases, there may be a small gap between the axial ring 150 and the shoulder 121 (i.e., the gland 103 is not necessarily completely closed).

In FIG. 1, the axial ring 150 is shown as being part of the socket 102 while the shoulder 121 is part of the plug 101. In such examples, the socket gland surface 160 is defined in part by the first axial face of the base portion 140 and in part by the axial ring 150, while the plug gland surface 130 may include the shoulder 121.

In other examples, the axial ring 150 may be part of the plug 101 and the shoulder 121 may be part of the socket 102. In such examples, the plug gland surface 130 is defined in part by the axial face of the base portion 120 and in part by the axial ring 150, while the socket gland surface 160 may include the shoulder 121.

In still other examples, there may be two axial rings 150 (and no shoulder 121), with one axial ring 150 protruding from the base portion 120 of the plug 101 and the other axial ring 150 protruding in an opposite direction from the base portion 140 of the socket 102. In such examples, the plug gland surface 130 is defined in part by one of the axial rings 150 and the socket gland surface 160 is defined in part by the other one of the axial rings 150, and the two axial rings 150 may face one another (in some cases, contact one another) in the mated state and together define the radial bounds of the gland 102.

As shown in FIG. 1, the plug gland surface 130 and the socket gland surface 160 comprises various sealing surface features 135 and complementary sealing surface features 165 which engage the O-ring 180. The sealing surface features 135, 165 are provided in pairs, with each pair comprising one sealing surface feature 135 of the plug gland surface 130 and a corresponding complementary sealing surface feature 165 of the socket gland surface 160. The two corresponding sealing surface features 135/165 of a given pair engage diametrically opposite non-radial portions of the O-ring 180 such that the two sealing surface features 135/165 compress the O-ring therebetween and form a non-radial seal pair. A non-radial portion or side of the O-ring 180 refers to a portion of the O-ring which does not face in a radial direction. In other words, the portion or side is non-radial if all of the normal vectors in that portion of the O-ring 180 point in a non-radial direction (a normal vector referring to a vector (arrow) originating at a point on the surface of the O-ring 180 which points perpendicular to the surface). Examples of non-radial portions/sides of the O-ring 180 include axial sides, which face in axial directions, and diagonal sides, which face directions partway between the axial and radial directions.

For example, the sealing surface features 135 of the plug gland surface 130 may include a face-seal surface feature 131, in which case the complementary sealing surface features 165 of the socket gland surface 160 may include a face-seal surface feature 161 which forms a pair with the face-seal surface feature 131. In such examples, the face-seal surface features 131 and 161 are configured to engage opposite axial sides of the O-ring 180 and to compress the O-ring 180 axially therebetween in response to the plug 101 and socket 102 being moved axially toward one another during mating. The "axial sides" of the O-ring which are contacted by the face-seal surface features 131 and 161 refers to the two portions of the surface of the O-ring which face in an axial direction, with one axial side facing axially toward the plug gland surface 130 and the other axial side facing axially toward the socket gland surface 160. More specifically, each axial side comprises a circular strip made up of portions of the surface of the O-ring which have an axially facing normal vector, or in other words portions of the surface of the O-ring which correspond to the greatest axial extent (apex) of the O-ring along an axial direction, or in other words portions of the surface of the O-ring which are intersected by a hypothetical cylinder which is coaxial with the O-ring and which has a radius that is halfway between an outer radius and an inner radius of the O-ring (i.e., the sides of the cylinder axially bisect the O-ring). The axial compression of the O-ring between the face-seal surface features 131 and 161 generates regions of high contact stress which form contact stress surface seals 181a and 181b at the locations where the face-seal surface features 131 and 161 engage the O-ring 180. These contact stress surface seals 181a and 181b together form a non-radial seal pair, which in this case is a face seal pair. In a cross-section, a compression line 171 of the face seal pair (the line between seals 181a and 181b along which the O-ring is compressed by the surface features 131 and 161) is parallel to the axis 195.

In some examples, the face-seal surface features 131 and 161 comprise protrusions which, in a cross-section, protrude axially from the adjoining portions of the plug gland surface 130 or socket gland surface 160, respectively. In the mated state, the protrusions which form the face-seal surface features 131 and 161 are radially aligned with one another and protrude in opposite directions towards one another. The protrusion forming the face-seal surface feature 131 extends circumferentially around the axis 195p such that, from a front-view perspective along the axis 195p, the protrusion has the general shape of an annular ridge. The protrusion forming the face-seal surface feature 161 similarly extends circumferentially around the axis 195s in the general shape of an annular ridge. In some examples, for each of the face-seal surface features 131 and 161, a normal vector at an apex thereof may be parallel to the compression line 171 and the axis 195. The protrusions may help to concentrate the contact forces in a smaller area, which increases the pressure and magnifies the local contact-stress, thus creating a more robust contact-stress surface seal.

As another example, the sealing surface features 135 of the plug gland surface 130 may include a first angular-seal surface feature 132, in which case the complementary sealing surface features 165 of the socket gland surface 160 may include a corresponding first angular-seal surface feature 162 which forms a pair with the first angular-seal surface feature 132. In such examples, the first angular-seal surface features 132 and 166 are configured to engage diagonally opposite sides of the O-ring 180 partway between the axial and radial sides of the O-ring and to compress the O-ring therebetween. More specifically, in some examples, each diagonally opposite side may comprise a circular strip made up of portions of the surface of the O-ring which are intersected by a hypothetical cone which is coaxial with the O-ring and whose sides diagonally bisect the O-ring. The diagonal compression of the O-ring between the first angular-seal surface features 132 and 162 generates regions of high contact stress which form contact stress surface seals 182a and 182b at the locations where the first angular-seal surface features 132 and 162 engage the O-ring 180. These contact stress surface seals 182a and 182b together form a non-radial seal pair, which in this case is an angular seal pair. In a cross-section, a compression line 172 of the angular seal pair (the line between seals 182a and 182b along which the O-ring is compressed by the surface features 132 and 162) is at an angle θ relative to the axis 195, where ∥*θ*∥ < 90°. In some examples, θ=45°. In some examples, 40° < θ₁ < 50° (i.e., θ₁=45°±5°). In some examples, 30° < θ < 60° (i.e., θ=45°±15°). In some examples, 15° < θ < 75° (i.e., θ=45°±30°).

In some examples, the angular-seal surface features 132 and 162 comprise sloped and/or curved engagement surfaces which face generally towards one another and which engage the diagonally opposite sides of O-ring. These engagement surfaces may have normal vectors which point diagonally. Moreover, in contrast to the face-seal surface features 131 and 161 which are radially aligned with one another in the mated state, the angular-seal surface features 132 and 162 are radially offset from one another. In other words, one of the angular-seal surface features 132 and 162 is disposed farther radially outward than the other, with the axial sides of the O-ring being positioned radially between the two angular-seal surface features 132 and 162. Supposing for the sake of discussion that the angular-seal surface feature 132 is positioned more radially inward, when the plug 101 and socket 102 are moved axially towards one another, the surface feature 132 contacts the O-ring and the sloped/curved surface thereof pushes the O-ring diagonally outward and toward the socket 102 (i.e., in a direction which is generally perpendicular to its slope). Simultaneously, the angular-seal surface feature 162, which in this hypothetical is positioned more radially outward, contacts the diagonally opposite side of the O-ring and the sloped/curved surface thereof pushes the O-ring diagonally inward and toward the plug 101 (i.e., in a direction perpendicular to its slope). Thus, with diagonally opposite sides of the O-ring being pushed in diagonally opposite directions, the O-ring is compressed diagonally between these two angular-seal surface features 132 and 162. If instead the angular-seal surface feature 132 is positioned more radially outward than the angular-seal surface features 162, effects similar to the above-described would occur except along different directions, i.e., the angular-seal surface feature 132 would push the O-ring radially inward and towards the socket 102 while the angular seal surface feature 162 would push the O-ring radially outward and towards the plug 101. The sloped/curved engagement surfaces which form the angular-seal surface feature 132 extend circumferentially around the axis 195p, while the sloped/curved engagement surfaces which form the angular-seal surface feature 162 similarly extend circumferentially around the axis 195s. In some examples, for each of the angular-seal surface features 132 and 162, a direction perpendicular to the surface thereof may be parallel to the compression line 172 when in the mated state.

In some examples in which both the face-seal surface features 131 and 161 and the angular-seal surface features 132 and 162 are present, the angular-seal surface features 132 and 162 may include portions which are axially taller than the face-seal surface features 131 and 161. In other words, an apex of the angular-seal surface feature 132 may be located farther along the axial direction towards the socket 102 than is the apex of the face-seal surface features 131, and similarly an apex of the angular-seal surface feature 162 may be located farther along the axial direction towards the plug 101 than is the apex of the face-seal surface features 161. This arrangement may allow for stronger diagonal compression between the angular-seal surface features 132 and 162.

As another example, the sealing surface features 135 of the plug gland surface 130 may include one or more additional angular-seal surface features, in which case the complementary sealing surface features 165 of the socket gland surface 160 may include corresponding additional angular-seal surface features. In such examples, each pair of corresponding angular seal-surface features are configured to engage opposite diagonal sides of the O-ring 180 partway between the axial and radial sides of the O-ring and to compress the O-ring therebetween forming an angular seal pair, in a similar fashion as the first angular-seal surface features 132 and 162. Each angular seal pair may have a compression line which is at a different angle relative to the axis 195 than the compression lines of the other angular seal pairs. For example, if a first angular seal pair has a compression line with angle θ₁ = 45° relative to the axis 195, a second angular seal pair may have a compression line with angle θ₂ = -45° relative to the axis 195, so that the two compression lines extend in opposite diagonal directions (e.g., in an X-shape). (In this context, a negative value for θ means the angle is measured in an opposite direction from the axis 195 relative to a positive value θ, for example if positive θ is measured clockwise relative to the axis 195 then negative θ is measured counterclockwise relative to the axis.)

The description above focused on the surface features 131, 132, 161, and 162 for ease of understanding, but it should be understood that examples disclosed herein may include any desired combinations of two or more pairs of sealing surface features 135/165 which form two or more non-radial seal pairs. In particular, some examples comprise a pair of face-seal surface features 131 and 161 to form a face seal pair and a first pair of angular-seal surface features 132 and 162 to form an angular seal pair; other examples comprise a first pair of angular-seal surface features 132 and 162 to form a first angular seal pair and a second pair of angular-seal surface features to form a second angular-seal pair (without any face-seal surface features); other examples comprise a pair of face-seal surface features 131 and 161 to form a face seal pair, a pair of first angular-seal surface features 132 and 162 to form a first angular seal pair, and a second pair of angular-seal surface features to form a second angular seal pair; other examples comprise three or more pairs of angular seal surface features (without any face-seal surface features); and other examples comprise a pair of face-seal surface features to form a face seal pair and three or more pairs of angular seal surface features to form three or more angular seal pairs.

In some examples, the O-ring 180 is carried by the plug 101 prior to mating, with the O-ring 180 resting against a portion of the outer surface of the mating protrusion 110 which is also part of the plug gland surface 130. In some of these examples, the outer surface of the mating protrusion 110 may include a retention feature (e.g., detent) to hold the O-ring 180 on the plug 101. In some examples, the O-ring 180 is carried by the socket 102 prior to mating, with the O-ring 180 resting against a portion of the socket gland surface 160. In some of these examples, the axial face of the base portion 140 may include a groove into which the O-ring 180 is partially received to hold the O-ring on the socket 102.

The fitting 100 may also include, in some examples, attachment features (not illustrated) to hold the plug 101 and socket 102 together in the mated state. In some examples, the attachment features may include portions of the plug 101 and socket 102 which engage one another to hold the plug 101 and socket 102 together. In some examples, the attachment features may include an intermediate part (e.g., threaded sleeve), which engages each of the plug 101 and 102 to hold them together.

For example, a threaded sleeve may be disposed around the plug 101 and socket 102, with the plug 101 and socket 102 inserted into a central bore of the threaded sleeve, and internal threading of the threaded sleeve may engage with external threading of the plug 101 and the socket 102, thereby holding them together. The external threading of the plug 101 may be formed, for example, in an outer radial surface of the base portion 120, and the external threading of the socket 102 may be formed in the outer radial surface(s) of the axial ring 150 and/or base portion 140.

In another example, the plug 101 and socket 102 may comprise complementary threads which engage directly (without an intermediate part) to hold the plug 101 and socket 102 together. For example, the plug 101 may comprise external threading and the socket 102 may comprise internal threading (e.g., on a portion (not illustrated) which protrudes axially from the base portion 140 and radially surrounds the base portion 120 when mated) which engages the external threading of the plug 101. Or, in another example, the socket 102 comprises external threading and the plug 101 comprises internal threading (e.g., on a portion (not illustrated) which protrudes axially from the base portion 120 and which radially surrounds the axial ring 150 and/or base portion 140 when mated) which engages the external threading of the socket 102.

Turning now to FIGs. 2-14, an example liquid cooling fluid O-ring gland fitting 100 (fitting 200) will be described. The fitting 200 is one example implementation of the fitting 100 described above, and some components of the fitting 200 thus correspond to (i.e., are implementation examples of) components of the fitting 100. Such corresponding components are given similar reference numbers having the same last two digits, such as 101 and 201. In some cases, descriptions above of aspects of the fitting 100 apply also to the corresponding components of the fitting 200 described below, unless otherwise indicated or logically contradictory, and thus duplicative description of such aspects may be omitted below. Although the fitting 200 is one example implementation of the fitting 100, the fitting 100 is not limited to just the fitting 200.

References are made herein to various directional terms, such as axial, radial, distal, proximal, outward, inward, etc. These terms are used in relation to the objects as depicted in the figures and do not have any relationship to any external reference frame, such as the earth. Axial refers to a direction parallel to an axis 295p of the plug 201, an axis 295s of the socket 202, and/or an axis 295 of the fitting 200, depending on context. Proximal and distal refer to two opposite axial directions as depicted in FIG. 2. Radial refers to any direction perpendicular to and intersecting the axes 295p, 295s, and/or 295, depending on context. Outward and inward refer to opposite axial directions, with outward referring to a radial direction pointing away from the axes 295p, 295s, and/or 295 and inward referring to a radial direction pointing toward the axes 295p, 295s, and/or 295 (note that whether a given direction is outward or inward may depend on which side of the axes 295p, 295s, and/or 295 the direction is being considered from, as a direction which points inward on one side of the axes 295p, 295s, and/or 295 will point outward on the other side of the axes). Other directional or relational terms used herein but not mentioned above are similarly to be understood based on the orientation depicted in the figures and are not limited relative to an external reference frame.

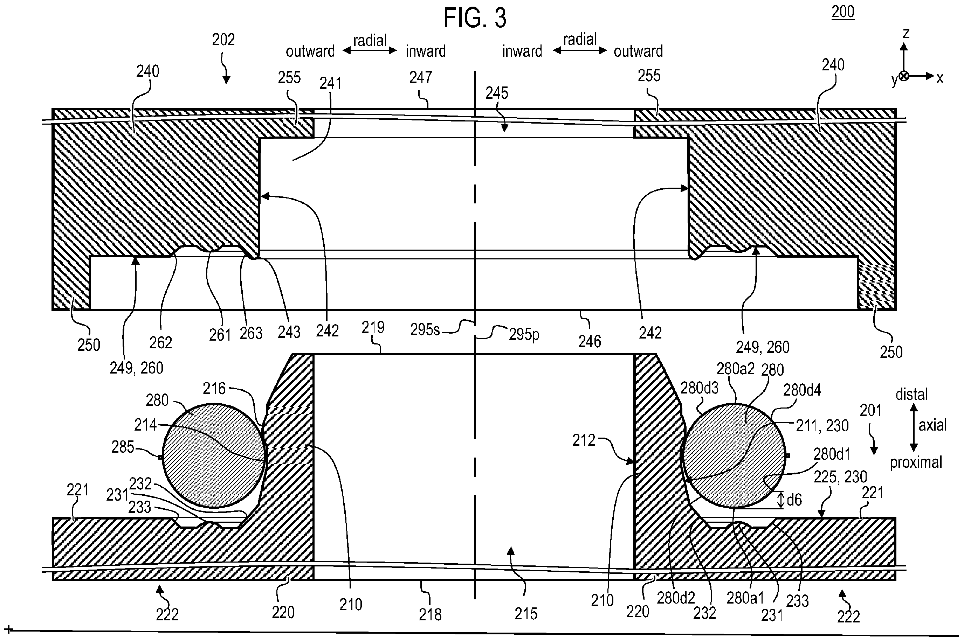

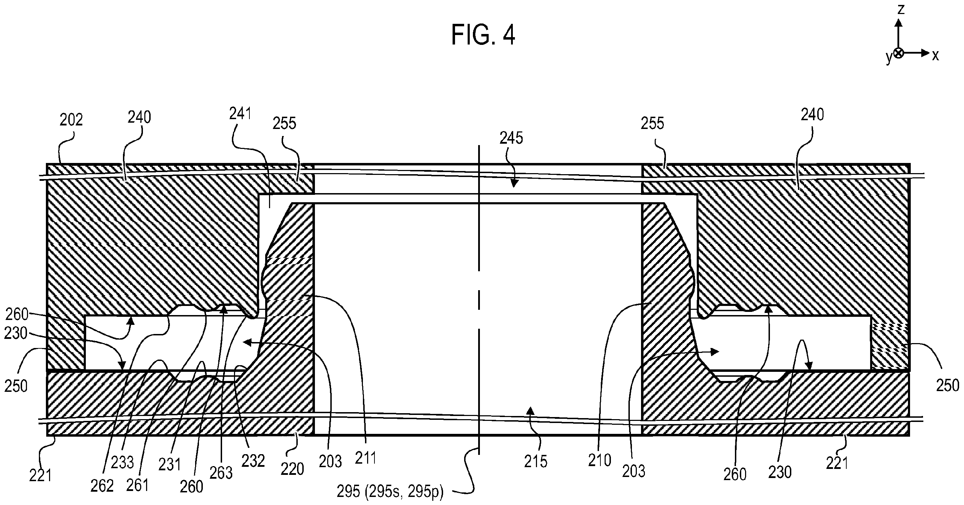

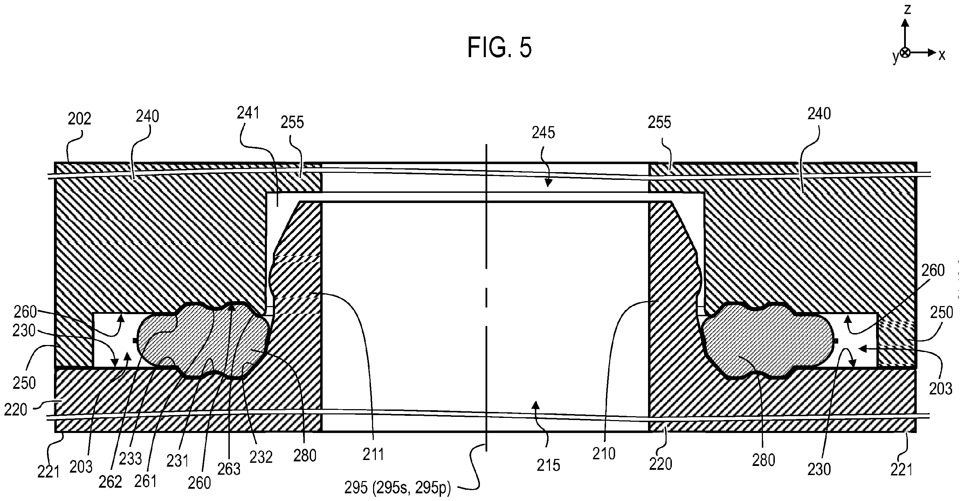

As shown in FIGs. 2-5, the fitting 200 comprises a plug 201, a socket 202, and an O-ring 280 (the O-ring is omitted from view in FIGs. 2 and 4 to make other aspects visible). FIGs. 2 and 3 show the fitting 100 in a non-mated state in which the plug 201 and socket 202 are separated. FIGs. 4 and 5 show the fitting in a mated state in which the plug 201 and socket 202 are mated together and the O-ring 280 is compressed therebetween. FIGs. 12 and 13 show perspective views of the plug 201 and socket 202 in isolation, whereas FIGs. 2-11 show the plug 201, socket 202, and (in some cases) the O-ring 280 together in various mated or non-mated states.

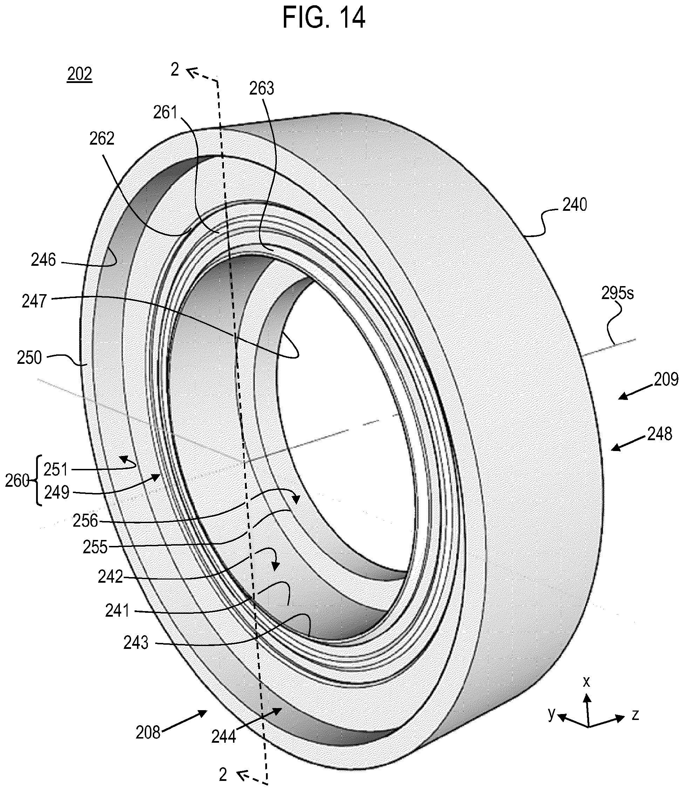

The fitting 200 may be used, for example, in a liquid cooling loop for cooling an information processing device. As shown in FIGs. 2 and 13, the plug 201 has a first end 206 configured to be connected to, or which is an integral part of, a first liquid cooling component (e.g., a pipe, a pump, a manifold, etc.) and a second end 207 configured to mate with the socket 202. Similarly, as shown in FIGs. 2 and 14, the socket 202 has a first end 208 configured to mate with the plug 201 and a second end 209 configured to mate with a second liquid cooling component (e.g., a pipe, a pump, a manifold, etc.). When the plug 201 and socket 202 are mated together this creates a fluid connection between the two liquid cooling components.

As shown in FIGs. 2 and 13, the plug 201 comprises a base portion 220 at the first end 206, a mating protrusion 210 at the second end 207, and a channel 215 extending along an axis 295p, with the channel 215 forming the liquid flow path through the plug 201. These will be described in turn below.

The base portion 220 has a first side 222 (corresponding to the first end 206 of plug 201) and a second side 223 opposite the first side 222. The first side 222 may be configured to be connected to, or is an integral part of, a first liquid cooling component via a permanent or semi-permanent connection. In the figures, the first side 222 is illustrated as having a simple flat surface for ease of illustration, but in practice the first side 222 could take on a variety of different shapes and may include various connection features (not shown) for connecting to the first liquid cooling component and/or other structures. A person a person of ordinary skill in the art would be familiar with various types of fitting connection features which could be used as part of the first side 222 base portion 220, and therefore these details are not illustrated herein.

The mating protrusion 210 protrudes axially (along the +z direction in FIG. 2) from the second side 223 of the base portion 220. A distal end of the plug 201 corresponds to a second end 207 of the plug 201, opposite from the first end 206. The mating protrusion 210 has the general shape of a right circular hollow cylinder (i.e., a cylindrical shell or pipe-like shape), except that the outer radial surface 211 tapers towards the distal end and has various contours or surface features. Specifically, the outer radial surface 211 includes a tapering lead-in feature 217 at the distal end of the mating protrusion 210, with the lead-in feature 217 sloping radially outward from an initial radius of r2 at the distal end to a final radius of r3 at the proximal end, with r3 > r2. Proximal of the lead-in feature 217 the outer radial surface 211 compress an O-ring retention feature 216 in the form of a protrusion with a radius at its apex of r4. Proximal of the O-ring retention feature 216 the outer radial surface 211 comprises an O-ring seat 214 with radius of r5, wherein r5 < r4. In some examples, r5 = r3. Proximal of the O-ring seat 214 is a ramp 213, which slopes radially outward starting from an initial radius of r5 at a distal end thereof to a final radius of r6 at the proximal end thereof, wherein r6 > r5. The lead-in feature 217, O-ring retention feature 216, O-ring seat 214, and ramp 213 will be described in greater detail below.

The channel 215 extends along an axis 295p through both the base portion 220 and the mating protrusion 210, with radially inward facing surfaces 212 defining circumferential bounds of the channel 215. The radially inward facing surface 212 may be part of the base portion 220 and part of mating protrusion 210. A radius of the channel 215 is referred to herein as r1, as shown in FIG. 2. The channel 215 has two openings at opposite ends thereof, with a first opening 218 being located in the first side 222 of the base portion 220 at the first end 208 of the plug 201 and a second opening 219 being located in a distal end of the mating protrusion 210 at the second end 207 of the plug 201. The channel 215 is fluidically coupled to the first liquid cooling component via the first opening 218 when the component is coupled to the base portion 220.

Turning now to the socket 202, as shown in FIGs. 2 and 14, the socket comprises an axial ring 250 at the first end 208, a base portion 240 at the second end 209, and a channel 245 extending along an axis 295s, with the channel 245 forming the liquid flow path through the socket 202. These will be described in turn below.

The base portion 240 has a first side 244 and a second side 248 opposite the first side 244 (the second side 248 of base portion 240 corresponding to the second end 209 of the socket 202). The second side 248 is configured to be connected to a second liquid cooling component. Like the first side 222 of the plug 201, the second side 248 of the socket 202 is illustrated herein as a simple flat surface merely for ease of illustration but can take on any desired shape in practice and may include various connection features (not illustrated) to facilitate connection to the second liquid cooling component. The first side 244 of base portion 240 comprises an axial face 249 and a mating recess 241 which is recessed axially (along the +z direction) from the axial face 249. The mating recess 241 comprises a cylindrical bore defined between radially inward facing surface 242, with the bore having a radius r8 equal to or just slightly larger than (e.g., up to 0.05mm larger than) the largest outer radius of the portion of the mating protrusion 210 which is received in the mating recess 241. Specifically, in some examples, the radius r4 of the apex of the O-ring retention feature 216 may be the largest radius of any portion of the mating protrusion 210 which is received in the mating recess 241, and therefore in these examples r8 is equal to, or just slightly larger than r4. The base portion 240 may further comprise a shelf 255 in the shape of an annular ring encircling the axis 295, which defines a distal boundary of the mating recess 241 and faces the mating protrusion 210 in the mated state. The mating recess 241 also has a rim 243 at a proximal end thereof (opposite from the shelf 255), which is formed at the intersection of the radially inward facing surface 242 and the axial face 249. The rim 243 may have a rounded or chamfered edge to facilitate smooth engagement with tapered lead-in 217 of mating protrusion, as will be described below.

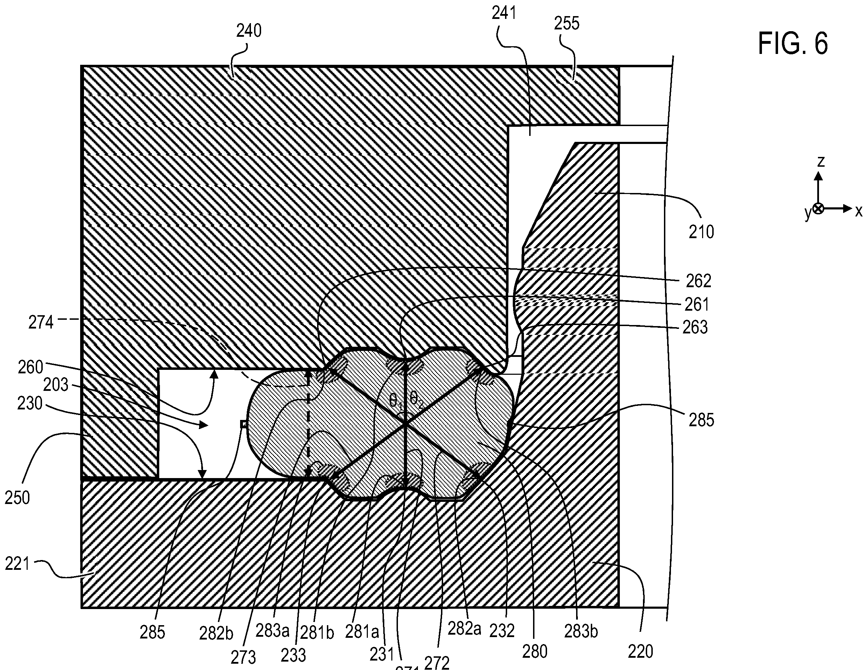

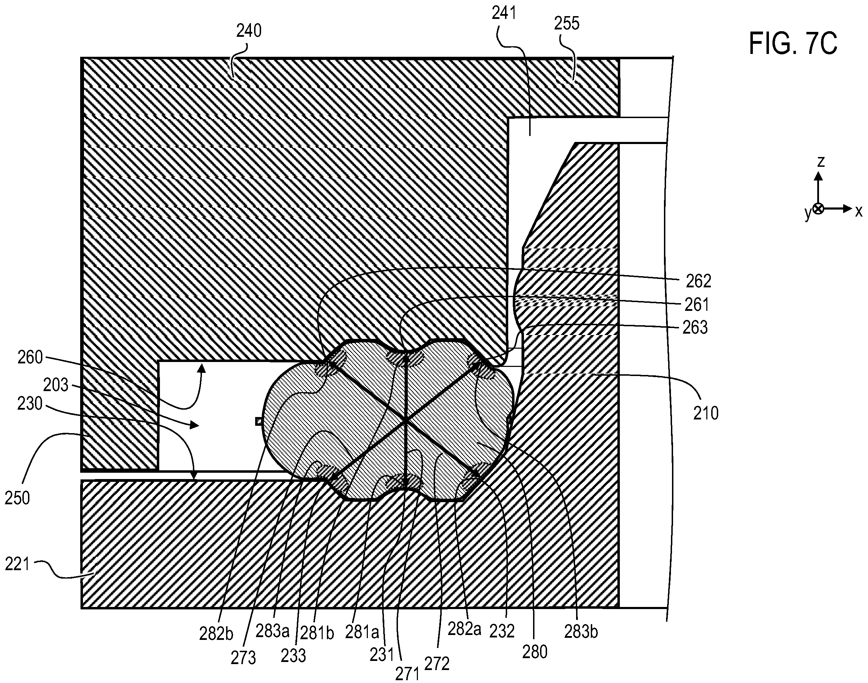

In the illustrated example, the axial ring 250 is disposed at the first end 208 of the socket 202, with the axial ring protruding axially (in the -z direction) from the axial face 249 of the base portion 240. (In other examples, the axial ring 250 could instead be moved from the socket 202 to the plug 201 instead of on the socket 202, with such an axial ring 250 protruding in the +z direction from the shoulder 221 and engaging with axial face 249.) The axial ring 250 has the shape of a rectangular toroid (a ring with a square cross-section) encircling the axis 295s. The axial ring 250 may cooperate with an axial face 225 of the shoulder 221 of the base portion 220 of the plug 201 to define a gland 203, as will be described in greater detail below. In some examples, axial ring 250 does not directly participate in making any seals. Instead, in some examples, one purpose of the axial ring 250 is to cover and protect the O-ring 280 from contact by external objects, which could possibly damage the O-ring or interfere with a seal. Thus, as shown in FIGs. 5 and 6, in the mated state, the axial ring 250 may be positioned directly opposite from and facing the shoulder 221 with either a small gap or no gap therebetween to prevent all but very small objects from entering into the gland 203. Another purpose of the axial ring 250 may be to form a stop corresponding to a nominal mating position of the socket 202 and plug 201 and also to a desired compression amount for the O-ring 280. More specifically, in some examples, the axial ring 250 may contact the shoulder 221 when the socket 202 and plug 201 are fully mated, and this contact may prevent further axial movement of the plug 201 and socket 202 toward one another, which might over compress the O-ring 280. However, in some cases, in some cases there may be a small gap between the axial ring 250 and shoulder 221, as shown in FIG. 7C. This may occur due to tolerances in the parts and/or may be part of the nominally-specified dimensions of the parts. In some examples, when the plug 201 and socket 202 are mated, the axial ring 250 and the shoulder 221 contact one another if the parts are at one extreme of their respective tolerance ranges (see FIG. 6) but do not contact one another if the parts are at an opposite extreme of their respective tolerance ranges (see FIG. 7C) or at their nominally specified dimensions.

The channel 245 extends along an axis 295s through the socket 202. Radially inward facing surfaces of the socket 202 define circumferential bounds of the channel 245, including a radially inward facing surface 251 of the axial ring 250 which defines one portion of the channel 245, the radially inward facing surface 242 of the mating recess 241 which defines another part of the channel 245, and a radially inward facing surface 256 of the shelf 255 which defines still another portion of the channel. The various portions of the channel may have different radii, as illustrated in FIG. 2. In particular a radius of the portion of the channel 245 defined by surface 256 is r7, a radius of the portion of the channel 245 defined by surface 242 is r8, and a radius of the portion of the channel 245 defined by surface 251 is r9, wherein r7 < r8 < r9. In some examples, r7 = r1. The channel 245 comprises two openings at opposite ends thereof, with a first opening 246 being located at the first end 208 of the socket 202 and a second opening 247 at the second end 209 of the socket 202. The channel 245 is fluidically coupled to the second liquid cooling component via the first opening 246 when the component is coupled to the base portion 240.

When the plug 201 and socket 202 are mated, the mating protrusion 210 is inserted through the first opening 246 past the axial ring 250 and into the mating recess 241, such that the second opening 219 is contained within and fluidically coupled to the channel 245, as illustrated in FIG. 4. Thus, in the mated state, the channels 215 and 245 are fluidically coupled together and thus liquid can flow from the channel 215 into the channel 245, or vice versa. In addition, in the mated state, the axes 295p and 295s may be substantially aligned with one another (i.e., coaxial), and thus in this state the axes 295p and 295s may be referred to individually or collectively as an axis 295 of the fitting 200, as shown in FIG. 4. This alignment may be achieved through the interaction of various engagement and alignment features, as will be described in greater detail below in relation to FIGs. 8-12.

As shown in FIGs. 2, 13 and 14, the plug 201 and socket 202 comprise a plug gland surface 230 and a socket gland surface 260, respectively. When the plug 201 and socket 202 are mated, these gland surfaces 230, 260 are disposed opposite one another and cooperate to define a gland 203 therebetween, as shown in FIG. 4. The gland 203 is a volume between the mated plug 201 and socket 202 in which the O-ring 280 is disposed, as shown in FIG. 5.

The O-ring 280 is carried by the plug 201 prior to mating, as shown in FIG. 3. Specifically, as shown in FIG. 2, the radially outer surface 211 of the mating protrusion 210 comprise an O-ring seat 214 and an O-ring retaining feature 216. The O-ring retaining feature 216 comprises a radial protrusion (ridge) adjacent the O-ring seat 214. As shown in FIG. 3 a radially inner side of the O-ring 280 rests against the O-ring seat 214, with the mating protrusion 210 abutting the O-ring retaining feature 216 such that the O-ring retaining feature 216 keeps the O-ring 280 from coming off the end of the mating protrusion 210. The O-ring seat 214 and the O-ring retaining feature 216 are arranged such that the O-ring 280 is positioned distally of the gland surface 230, i.e., in a pre-mating state, the O-ring 280 is not in contact with the gland surface 230. In some examples, the nominal, unstretched, inner diameter of the O-ring 280 is less than r5 (the outer diameter of the O-ring seat 214), so that the O-ring 280 is in a slightly stretched state when resting on the O-ring seat 214, which helps to hold the O-ring 280 on the mating protrusion 210.

As shown in FIGs. 2 and 13, the plug gland surface 230 is defined in part by the base portion 220 and in part by the mating protrusion 210. Specifically, the base portion 220 comprises a shoulder 221 which protrudes radially outward from the base (attached end) of the mating protrusion 210, with the shoulder 221 having an axial face 225 which faces in a generally axial (+z) direction towards the socket 202. The axial face 225 of the shoulder 221, together with part of the outer radial surface 211 of the mating protrusion 210, form the plug gland surface 230.

As shown in FIGs. 2 and 14, the socket gland surface 260 is defined in part by the base portion 240 and in part by the axial ring 250. A radially inward facing surface 251 of the axial ring 250, together with the axial face 249 of the base portion 240, form the socket gland surface 260.

As the plug 201 and socket 202 are mated together, the gland surfaces 230 and 260 move axially towards one another. Eventually, the gland surfaces 230 and 260 are close enough to one another that they contact and begin to compress the O-ring 280 therebetween. Further movement of the gland surfaces 230 and 260 closer together further compresses the O-ring, until, in the fully mated position, the O-ring is compressed sufficiently to form a plurality of different non-radial seal pairs, as shown in FIGs. 5 and 6 and as will be described below. In addition, in the fully mated position, the axial ring 250 is disposed opposite from the shoulder 221, partially enclosing the gland 203, as shown in FIGs. 4-6. In some cases, the axial ring 250 may abut the shoulder 221 in the mated state, as shown in FIG. 6. In other cases, there may be a small gap between the axial ring 250 and the shoulder 221 (i.e., the gland 203 is not necessarily completely closed), as shown in FIG. 7C.

As best seen in FIGs. 2, 13, and 14, the plug gland surface 230 and the socket gland surface 260 comprises various surface features. As shown in FIGs. 5 and 6, these surface features engage with the O-ring 280 in the mated state. Specifically, as shown in FIGs. 2 and 13, the plug gland surface 230 includes a face-seal surface feature 231, a first angular-seal surface feature 232, and a second angular-seal surface feature 233. Correspondingly, as shown in FIGs. 2 and 14, the socket gland surface 260 includes a face-seal surface feature 261, a first angular seal surface feature 262, and a second angular seal surface feature 263. As shown in FIG. 5, the face-seal surface features 231 and 261 form a face-seal pair by engaging opposite axial sides of the O-ring 280 and compressing the O-ring axially therebetween along compression line 271, the first angular-seal surface feature 232 and 262 form a first angular-seal pair by engaging opposite diagonal sides of the O-ring 280 and compressing the O-ring diagonally therebetween along compression line 272, and the second angular-seal surface feature 233 and 263 form a second angular-seal pair by engaging opposite diagonal sides of the O-ring 280 and compressing the O-ring diagonally therebetween along compression line 273. The aforementioned axial and diagonal sides of the O-ring are labeled in FIG. 3 as axial sides 280a1 and 280a2 and diagonal sides 280d1, 280d2, 280d3, and 280d4, and using this nomenclature the face-seal surface features 231 and 261 contact the axial sides 280a1 and 280a2, respective, the first angular-seal surface features 232 and 262 contact the diagonal sides 280d2 and 280d4, respective, and the second angular-seal surface features 233 and 263 contact the diagonal sides 280d1 and 280d3, respectively.

The axial-seal pair comprises contact-stress seals 281a and 281b, which are formed by regions of the O-ring 280 experiencing relatively higher contact stress due to axial compression by the opposing face-seal surface features 231 and 261. As shown in FIG. 6, the contact-stress seal 281a is formed in the axial side of the O-ring facing axially toward the plug gland surface 230 (-z direction), i.e., the axial side 280a1 labeled in FIG. 3, and the contact-stress seal 281b is formed in the axial side of the O-ring facing axially toward the socket gland surface 260 (+z direction), i.e., the axial side 280a2 labeled in FIG. 3. The axial compression is represented in FIG. 6 by compression line 271, which shows the direction of compression along one cross-sectional slice of the O-ring. The compression line 271 is parallel to the axis 295.

As shown in FIG. 6, the face-seal surface features 231 and 261 each comprise a protrusions which, in a cross-section, comprises a rounded (arched) bump which protrudes axially (±z direction) from the adjoining portions of the plug gland surface 230 or socket gland surface 260, respectively. As shown in FIGs. 12 and 13, when viewed in three-dimensions, the face-seal surface features 231 and 261 have the form of a circular ridge or axially-protruding ring encircling the axes 295p and 205s. In the mated state, the protrusions which form the face-seal surface features 231 and 261 are radially aligned with one another and protrude in opposite directions towards one another. Specifically, an apex of the face-seal surface feature 231 is located at a radius of r11 and an apex of the face-seal surface feature 261 is located at a radius of r14, and in some examples r11 = r14. The protrusion forming the face-seal surface feature 231 extends circumferentially around the axis 295p such that, from a front-view perspective along the axis 295p, the protrusion has the general shape of an annular ridge with an arched cross-sectional profile. The protrusion forming the face-seal surface feature 261 similarly extends circumferentially around the axis 295s in the general shape of an annular ridge. Moreover, for each of the face-seal surface features 231 and 261, a normal vector at an apex thereof is parallel to the compression line 271 and the axis 295. The protrusions may help to concentrate the contact forces in a smaller area, which increases the pressure and magnifies the local contact-stress, thus creating a more robust contact-stress surface seal 281a or 281b.
The first angular-seal pair comprises contact-stress seals 282a and 282b, which are formed by regions of the O-ring experiencing relatively higher contact stress due to diagonal compression by the opposing angular-seal surface features 232 and 262. As shown in FIG. 6, the contact-stress seal 282a is formed in a diagonal side of the O-ring facing toward the plug gland surface 230 along a first direction partway between the axial and radial directions (e.g., partway between the -z and +x directions), i.e., the diagonal side 280d2 labeled in FIG. 3. The corresponding contact-stress seal 282b is formed in a diametrically opposite diagonal side of the O-ring facing toward the socket gland surface 260 along a second direction partway between the axial and radial directions, which is opposite the first direction (e.g., partway between the +z and -x directions), i.e., the diagonal side 280d4 labeled in FIG. 3. The diagonal compression is represented in FIG. 6 by compression line 272, which shows the direction of compression along one cross-sectional slice of the O-ring. In a cross-section, the compression line 272 is at an angle θ₁ relative to the axis 295, where ∥*θ*₁∥ < 90°. In some examples, θ₁=45°. In some examples, 40° < θ₁ < 50° (i.e., θ₁=45°±5°). In some examples, 30° < θ₁ < 60° (i.e., θ₁=45°±15°). In some examples, 15° < θ₁ < 75° (i.e., θ₁=45°±30°).

As shown in FIG. 6, the angular-seal surface features 232 and 262 comprise sloped and/or curved engagement surfaces which face generally towards one another and which engage the diagonally opposite sides of O-ring 280. In a cross-section, these engagement surfaces have normal vectors which point diagonally. Specifically, the angular-seal surface feature 232 has a normal vector which points partway between the +z and -x directions (i.e., the normal vector has a negative x-component, zero y-component, and a positive z component), while angular-seal surface feature 262 has a normal vector which points partway between the -z and +x directions (i.e., the normal vector has a positive x-component, zero y-component, and a negative z component). In three dimensions, the respective sloped surfaces of the angular-seal surface features 232 and 262 encircle the axes 295p and 295s like the sloped surfaces of truncated cones, as shown in FIGs. 13 and 14. These sloped surfaces which make up the angular-seal surface features 232 and 262 are, in the mated state, at a same angle as one another relative to the axis 295, such as a 45° angle in some examples. Moreover, in contrast to the face-seal surface features 231 and 261 which are radially aligned with one another in the mated state, as shown in FIG. 6 the angular-seal surface features 232 and 262 are radially offset from one another, with the angular-seal surface features 262 being disposed farther radially outward than the angular-seal surface features 232 and with the axial sides of the O-ring 280 being positioned radially between the two angular-seal surface features 232 and 262. More specifically, the angular-seal surface feature 232 has a radius of r10 (e.g., the radius at a middle portion thereof), the angular-seal surface feature 262 has a radius of r15 (e.g., the radius at an apex thereof), the face seal surface feature 231 has a radius of r11 at the apex thereof, and the face seal surface feature 261 has a radius of r14 at the apex thereof, and in some examples r10 < r11 = r14 < r15, as shown in FIG. 2.

The slopes of the angular-seal surface features 232 and 262, together with them being positioned on opposite diagonal sides of the O-ring, allow these features to generate the diagonal compression of the O-ring 280 therebetween when the plug 201 and socket 202 are moved axially towards one another. The sloped/curved engagement surfaces which form the angular-seal surface feature 232 extend circumferentially around the axis 295p, while the sloped/curved engagement surfaces which form the angular-seal surface feature 262 similarly extend circumferentially around the axis 295s. For each of the angular-seal surface features 232 and 262, in a cross-section, a direction perpendicular to the surface thereof is generally parallel to (within ±15° of) the compression line 272 when in the mated state.

The second angular-seal pair comprises contact-stress seals 283a and 283b, which are formed by regions of the O-ring experiencing relatively higher contact stress due to diagonal compression by the opposing angular-seal surface features 233 and 263. As shown in FIG. 6, the contact-stress seal 283a is formed in a diagonal side of the O-ring facing toward the plug gland surface 230 along a third direction partway between the axial and radial directions (e.g., partway between the -z and -x directions), i.e., the diagonal side 280d1 labeled in FIG. 3. The corresponding contact-stress seal 283b is formed in a diametrically opposite diagonal side of the O-ring facing toward the socket gland surface 260 along a fourth direction partway between the axial and radial directions, which is opposite the third direction (e.g., partway between the +z and +x directions), i.e., the diagonal side 280d3 labeled in FIG. 3. The diagonal compression is represented in FIG. 6 by compression line 273, which shows the direction of compression along one cross-sectional slice of the O-ring. In a cross-section, the compression line 273 is at an angle θ₂ relative to the axis 295, where ∥*θ*₂∥ < 90°. In some examples, θ₂=-45°. In some examples, -40° < θ₂ < -50° (i.e., θ₂=-45°±5°). In some examples, -30° < θ₂ < -60° (i.e., θ₂=-45°±15°). In some examples, -15° < θ₂ < -75° (i.e., θ₁=-45°±30°). In some examples, the compression lines 273 and 272 cross one another with an angle therebetween of 90°.

As shown in FIG. 6, the angular-seal surface features 233 and 263 comprise sloped and/or curved engagement surfaces which face generally towards one another and which engage the diagonally opposite sides of O-ring 280. In a cross-section, these engagement surfaces have normal vectors which point diagonally. Specifically, the angular-seal surface feature 233 has a normal vector which points partway between the -z and +x directions (i.e., the normal vector has a negative x-component, zero y-component, and a negative z component), while angular-seal surface feature 262 has a normal vector which points partway between the +z and +x directions (i.e., the normal vector has a positive x-component, zero y-component, and a positive z component). These sloped surfaces which make up the angular-seal surface features 233 and 263 are, in the mated state, at a same angle as one another relative to the axis 295, such as a 45° angle in some examples. In some examples, the angle of the sloped surfaces of the first angular seal surface features 232 and 262 may be 90 degrees offset from the angle of the sloped surfaces of the second angular seal surface features 233 and 263. The angular-seal surface features 233 and 263 are radially offset from one another, and their slopes and opposing positions are what allow these features to generate the diagonal compression of the O-ring 280 therebetween when the plug 201 and socket 202 are moved axially towards one another. The sloped/curved engagement surfaces which form the angular-seal surface feature 233 extend circumferentially around the axis 295p, while the sloped/curved engagement surfaces which form the angular-seal surface feature 263 similarly extend circumferentially around the axis 295s. For each of the angular-seal surface features 233 and 263, in a cross-section, a direction perpendicular to the surface thereof is generally parallel to (within ±15° of) the compression line 273 when in the mated state.

As shown in FIG. 6, the face-seal surface feature 231 is disposed radially in between the first and second angular-seal surface features 232 and 233. Similarly, the face-seal surface feature 261 is disposed radially in between the first and second angular-seal surface features 262 and 263. More specifically, the angular-seal surface feature 233 has a radius of r12 (e.g., the radius at the apex thereof), the angular-seal surface feature 263 has a radius of r13 (e.g., the radius in a middle region thereof), the face seal surface feature 231 has a radius of r11 at the apex thereof, and the face seal surface feature 261 has a radius of r14 at the apex thereof, and in some examples r12 > r11 = r14 > r13, as shown in FIG. 2. In addition, in some examples, r12 = r15 and r10 = r13. Moreover, the compression line 273 is transverse to the compression line 272.

As shown in FIG. 3, a section of the O-ring 280 in the uncompressed state has a circular profile and therefore the axial side 280a1 thereof is positioned closer than are the diagonal sides 280d1 or 280d2 in the axial direction to the gland surface 230. Specifically, the diagonal side 280d1 of the O-ring 280 (which contacts the angular surface feature 233) is set back in the axial direction a distance d6 farther than the diagonal side 280d1 of the O-ring 280 (which contacts the angular seal surface feature 233). Because the diagonal sides 280d1 and 280d2 are set back relative to the axial side 280a1, if the surface features 231, 232, and 233 were all at the same axial height in the distal direction, then the face-seal surface feature 231 would contact the O-ring 280 and begin compressing it well before the angular-seal surface features 232 or 233 contacted the O-ring 280. The same is true for the surface features 261, 262, and 263. Thus, as the plug 201 and socket 202 are moved together, the degree of contact stress (deformation) generated by the face-seal surface features 231 and 261 would be greater than that generated by the angular seal surface features 232, 262, 233, and 263, which may result in the angular-seal pairs having less than desired sealing performance. Thus, to reduce this discrepancy in contact stress between the different seal pairs and allow all seal pairs provide a desired level of sealing performance, the face-seal surface features 231 and 261 may be axially recessed slightly relative to the angular-seal surface features 232, 233, 262, and 263. More specifically, the angular-seal surface features 232 and 233 may be axially taller than the face-seal surface feature 231 (i.e., the angular-seal surface features 232 and 233 are positioned farther in the distal direction than the apex of the face-seal surface feature 231), while the angular-seal surface features 262 and 263 are axially taller than the face-seal surface feature 261 (i.e., the angular-seal surface features 262 and 263 are positioned farther in the proximal direction than the apex of the face-seal surface feature 261). This allows the angular-seal surface features to contact and begin compressing the O-ring 280 sooner than they would if all surface features had the same axial height, and in some cases can allow for all surface features to begin compressing the O-ring 280 at approximately the same time. This results in increased contact stress at seals 282a, 282b, 283a, and 283b, and thus improved sealing performance.

In addition to the non-radial seal pairs described above, the fitting 200 may also include additional secondary seals. For example, O-ring 280 may be axially compressed along compression line 274 shown in FIG. 6 between portions of the gland surfaces 230 and 260 which face axially and which are adjacent to the angular-seal surface features 233 and 262. This axial compression creates an additional axial face-seal pair.

As can be seen in FIGs. 3 and 6, the O-ring 280 has flash 285 at either radial side thereof (which his exaggerated in the figures to make it more easily visible). However, because the non-radial seal pairs described above do not involve portions of the O-ring which have such flash 285, the flash 285 cannot interfere with these non-radial seals.

Additionally, a secondary radial seal may occur where the radially inward side of the O-ring contacts the radially outward surface 211 of mating protrusion 210. This secondary radial seal may suffer from the issues described above related to the flash 285 potentially impairing sealing performance, but nevertheless might provide some degree of additional sealing redundancy. However, as this is a radial seal, this secondary seal does not qualify as one of the non-radial seal pairs.

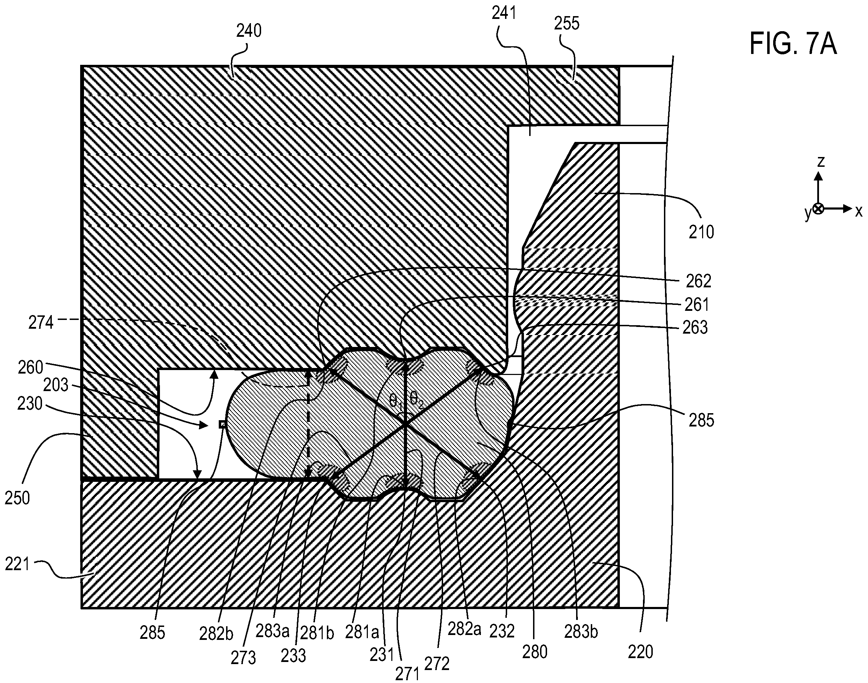

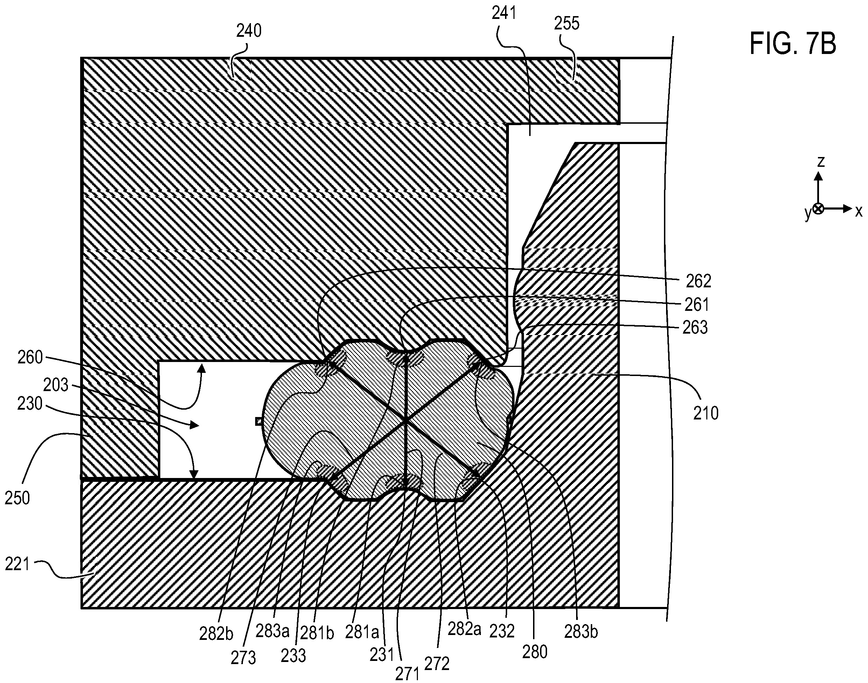

When the O-ring 280 is compressed between the gland surfaces 230 and 260, the O-ring 280 changes its shape (deforms) but does not appreciably change in volume (i.e., the O-ring 280 is made from a material that is "non-compressible" in the sense that the material does not significantly change its volume in response to increasing pressure). In particular, as the O-ring 280 is squeezed by motion of the plug 201 and socket 202 along the axial (±z) direction, the O-ring 280 deforms. This deformation may include a general reduction in the width of the O-ring i280n the axial (±z) direction. Because the volume of the O-ring 280does not significantly change, the reduction in axial width of the O-ring280 causes a corresponding expansion of the O-ring in other directions, including an expansion in the radial width of the O-ring 280. Thus, references herein to compressing the O-ring 280should be understood as applying forces/pressure to opposite sides of the O-ring 280to squeeze the O-ring 280therebetween, which may cause stress in and deformation of the O-ring 280but which do not necessarily change its overall volume. To account for the expansion of the O-ring 280 along the radial (±x) direction when compressed, as shown in FIGs. 6 and 7, the gland 203 is configured to have free space radially adjacent to the space normally occupied by the O-ring 280 prior to mating, with the free space being large enough to accommodate the shifted material of the O-ring 280 when mated. In other words, the volume of the gland 203 in the mated state is at least as large as the volume of the O-ring 280.

Moreover, in some examples, the gland 203 is configured to provide more extra space than may be needed merely to account for deformation of the O-ring 280 under compression. In other words, the volume of the gland 203 may exceed the volume of the O-ring 280. This additional space may be provided to account for the possibility of the O-ring 280 being larger-than-nominally specified and/or the gland 203 being smaller-than-nominally specified. The O-ring 280 may be larger-than-nominal due to manufacturing tolerances. Or, in some cases, an O-ring 280 may increase in volume (swell) over time due to absorption of liquid and/or thermal expansion. Similarly, the gland 203 maybe smaller-than-nominal due to manufacturing tolerances in the plug 201 and socket 202 or thermal variation. FIG. 7A shows an example in which the O-ring 280 is larger than nominally specified, and as can be seen by comparing FIG. 7A to FIG. 6, the increased volume of the larger O-ring 280 results in it expanding farther into the gland 203 in the radial direction. Similarly, if the gland 203 were smaller-than-nominal, the O-ring 280 would be compressed more (due to the smaller gland 203) and thus the O-ring 280 would expand farther radially into the gland 203 in a similar fashion. In other words, whether the O-ring 280 is on the large size, the gland is on the small size, or both, a similar result occurs which is the O-ring 280 is squeezed farther in the radial direction into the gland 203. However, because the gland 203 was oversized relative to the nominally-sized O-ring 280, the gland 203 can still adequately contain the O-ring 280 in in each of these cases. In other words, the nominally specified size of the gland 203 may be such that, if the plug 201 and socket 202 are both at the extremes of their respective tolerance ranges such that the gland 203 has is smallest size within tolerance, then this smallest gland 203 would still be large enough to accommodate the O-ring 280 when it is at the largest extreme of its tolerance range (in some cases, including a factor for swelling of the O-ring).

In addition, to accounting for a larger-than-nominal O-ring 280 and/or a smaller-than-nominal gland 203 as described above, the gland 203 is also configured to account for tolerances running in the other direction, i.e., a smaller-than-nominal O-ring 280 and/or a larger-than-nominal gland 203. When the O-ring 280 is smaller than nominal and/or the gland 203 is larger-than-nominal, the O-ring 280 will protrude less far in the radial direction into the gland 203, as shown in FIG. 7B. FIG. 7B shows this phenomenon occurring as a result of the gland 203 being larger-than-nominal due to the axial ring 250, but a similar effect would occur if the O-ring 280 were smaller-than-nominal. However, even in the worst-case-scenario in which the O-ring 280 is at its smallest extent within tolerances and when the gland 203 is at its largest extent within tolerances, all of the sealing surface features of the gland surfaces 230 and 260 are still able to contact and compress the O-ring 280 to form the non-radial seal pairs.

Furthermore, as shown in FIG. 7C, in some cases axial ring 250 might not fully contact the shoulder 221 in the mated state. This may also result in the size of the gland 203 increasing beyond its nominally-specified size, which in turn causes the O-ring 280 to be extend less far into the gland 203.

The mating sequence of the plug 201 and socket 202 will now be described with reference to FIGs. 8-12. In the description of this mating sequence, the plug 201 and socket 202 are shown at each successive stage of the mating process with the greatest degree of misalignment possible at that stage, in order to illustrate how engagement between features of the plug 201 and socket 202 can automatically guide the plug 201 and socket 202 into alignment. However, it should be understood that this merely illustrates the most extreme constraints and that, in practice, the plug 201 and socket 202 could be aligned to a greater degree at each stage of mating. Moreover, contact between surfaces is described in each stage of the mating sequence, but it should be understood that such contact may not occur (or may occur intermittently), e.g., if the plug 201 and socket 202 are not at the maximum degree of misalignment in a given stage, then there may be no contact between surfaces of the plug 201 and socket 202 at that timing. Furthermore, it should be understood that the surfaces being described extend circumferentially around the axes 295s and 295p, and the contact between these surfaces which is described below may refer to contact of only one portion of each surface while other portions of the surfaces (e.g., on an opposite side of the axis 295s or 295p) may not be in contact. I

In addition, in the description below, motion during the mating will be described primarily as motion of the plug 201 to simplify the description, but it should be understood that such descriptions refer to relative motion between plug 201 and socket 202. Thus, if some external reference frame (such as the ground) is considered, then the part or parts which move relative to the external reference frame may be different than described. For example, motion described herein as axial translation of the plug 201 in a distal (+z) direction could, when considered relative to some external reference frame, include any of the following: translation of the plug 201 distally relative to the external reference frame (e.g., the ground) while the socket 202 remains stationary relative to the external frame, translation of the socket 202 proximally relative to the external reference frame while the plug 201 remains stationary relative to the external reference frame, and simultaneous translation of the plug 201 distally and translation of the socket 202 proximally relative to the external reference frame. In other words, one can move the plug 201, the socket 202, or both relative to some external reference frame in order to achieve the mating, and any of those motions can be considered to be motion of the plug 201 relative to the socket 202.

As shown in FIG. 8, in an initial stage of mating, the user may grossly align the plug 201 relative to the socket 202 until the tapered lead-in 217 of the mating protrusion 210 engages with the rim 243 of the mating recess 241. At this stage of gross alignment, the axes 295p and 295s may be slightly misaligned from one another by up to an amount d2. For example, d2 may be equal to the radius r4 minus the radius r1 plus an overall alignment tolerance ε for the fitting 200 (the maximum tolerance for misalignment between the axes 295p and 295s in the fully mated state). In some examples, d2 = ±0.70mm and ε = ±0.05mm.

After the tapered lead-in 217 engages the rim 243, the mating sequence is continued by translating the plug 201 axially in the distal (+z) direction towards the socket 202, which results in the mating protrusion 210 advancing distally into the mating recess 241. As the mating protrusion 210 advances into the mating recess 241, the engagement between the tapered lead-in 217 and the rim 243 forces the plug 201 and socket 202 to move radially relative to one another such that the axes 295p and 295s are forced closer to alignment. Eventually, the rim 243 reaches the proximal end of the tapered lead-in 217, as shown in FIG. 9. In this state, the axes 295p and 295s have achieved a coarse alignment, meaning they may still be slightly misaligned but less so than in the gross alignment of FIG. 8. For example, in the coarse alignment of FIG. 9, the axes 295p and 295s may be misaligned by up to an amount d3 < d2. In some examples, d3 may be equal to radius r4 minus the radius r3 plus the tolerance ε. In some examples, d3 = 0.10mm.

The mating sequence then continues by further translating the plug 201 axially in the distal direction, which causes the rim 243 to traverse the outer surface 211 in the proximal direction until the rim 243 reaches the O-ring retaining feature 216, as shown in FIG. 10. Continued translation of the plug 201 distally causes the rim 243 to begin to slide up the O-ring retaining feature 216, and eventually, the rim 243 reaches the apex of the O-ring retaining features 216, as illustrated in FIG. 11. The distal side of the O-ring retaining feature 216 may be curved/sloped to make it easier for the rim 243 to slide up to the apex of the O-ring retaining feature 216. This sliding of the O-ring 280 up the retaining feature 216 further aligns the plug 201 relative to the socket 202 such that, once the inward surface 242 is positioned radially over (e.g., resting on) the apex of the O-ring retaining feature 216, the plug 201 and socket 202 are nominally fully aligned. In other words, once the inward surface 242 is positioned radially over the apex of the O-ring retaining feature 216, the axes 295p and 295s are within ε of being perfectly aligned (coaxial). In some examples, ε = 0.05mm. Although there may be some slight misalignment of the axes 295p and 295s in this state due to tolerances, for purposes of this disclosure, the axes 295p and 295s are considered as being "aligned" in this state and thus may be referred to as a single axis 295 of the fitting 200.

At some point during the insertion of the plug 201 into the socket 202, after the gross alignment illustrated in FIG. 8 and before O-ring is compressed between the plug 201 and socket 202, the gland surface 260 of the socket 202 comes into contact with the O-ring 280. As shown in FIG. 10, in the illustrated example this contact between gland surface 260 and O-ring 280 occurs after the rim 243 has reached the proximal end of the tapered lead-in 217 (after the state of FIG. 9) and before the rim 243 has climbed up the apex of the O-ring retaining features 216 (e.g., before the state of FIG. 11). In other examples, this contact between gland surface 260 and O-ring 280 may occur at some other timing during the mating sequence, such as while the rim 243 is still in contact with the tapered lead-in 217, as the rim 243 reaches the apex of the O-ring retaining feature 216, or after the rim 243 has moved proximally past the apex of the O-ring retaining feature 216.

Once the contact between gland surface 260 and O-ring 280 occurs, the mating sequence continues by further translation of the plug 201 axially in the distal direction, which causes the gland surface 260 to push the O-ring 280 proximally (-z direction) towards the gland surface 230 of the plug 201. This pushing of the O-ring 280 towards the gland surface 230 causes the O-ring 280 to begin to slide along the sloped ramp 213. The translation of the O-ring 280 along the sloped ramp 213 causes the O-ring to be stretched radially outward such that the diameter thereof expands. This stretching of the O-ring 280 can facilitate the sliding of the rim 243 of the mating recess 241 between the O-ring 280 and the mating protrusion 210 without pinching the O-ring 280 therebetween. Such pinching could result in seal failure and/or damage to the O-ring 280.

With continued translation of the plug 201 in the distal direction, eventually, the O-ring 280 will be pushed proximally far enough that it comes into contact with the gland surface 230 of the plug 201, as shown in FIG. 11. In the illustrated example, the contacting of the O-ring 280 with the gland surface 230 coincides with the rim 243 reaching the apex of the O-ring retaining feature 216, but this is merely one example and in other examples the contacting of the O-ring 280 with the gland surface 230 could occur at some other timing in the mating sequence, including after the rim 243 reaches the apex of the O-ring retaining feature 216 or before the rim 243 reaches the apex of the O-ring retaining feature 216.

Once the O-ring 280 is in contact with both the gland surfaces 230 and 260 (FIG. 11), continued axial translation of the plug 201 in the distal direction results in the O-ring 280 being compressed between the gland surfaces 230 and 260 and thus deformation of the O-ring 280. The farther that the plug 201 translates distally after the compression initially begins, the more the O-ring 280 is deformed and the greater the surface contact stresses created therein. In some examples, the face-seal surface features 231 and 261 may make first contact with the O-ring 280, and the angular-seal surface features 232, 233, 262, and 263 may subsequently make contact with the O-ring 280 as it begins to deform as a result of being compressed between the face-seal surface features 231 and 261. In other examples, all of the surface features may simultaneously contact the O-ring 280. In either case, as the plug 201 is translated distally into the socket 202, eventually all of the surface features 231, 232, 233, 261, 262, and 263 described above are brought into contact with the O-ring 280 and they begin to compress the O-ring 280 therebetween along the compression lines 271, 272, and 273 described above. Eventually, the fully mated state is reached in which the non-radial seal pairs described above have been formed, as shown in FIG. 12.

The fitting 200 may also include, in some examples, attachment features (not illustrated) to hold the plug 201 and socket 202 together in the mated state. In some examples, the attachment features may include portions of the plug 201 and socket 202 which engage one another to hold the plug 201 and socket 202 together. In some examples, the attachment features may include an intermediate part (e.g., threaded sleeve), which engages each of the plug 201 and 202 to hold them together. Such attachment feature are familiar to those in the art and thus are not shown or described in detail herein. It is noted that the radially outward facing surfaces of the shoulder 221, axial ring 250, and base portion 240 are depicted herein as flat surface merely to ease understanding, but in practice may include various surface features which may include some of the aforementioned attachment features, such as threading or other attachment features.

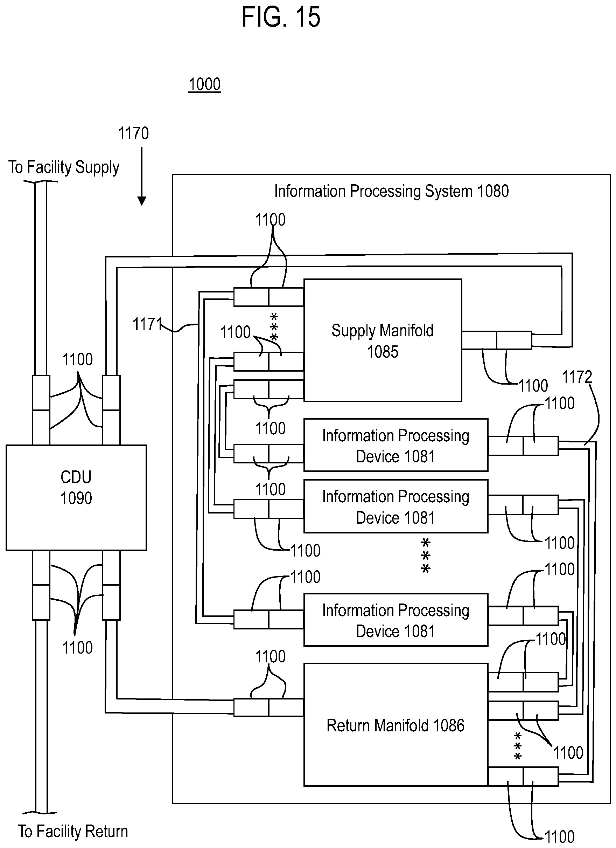

Turning now to FIG. 15, an example system 1000 is described. FIG. 15 is schematic in nature and is not intended to illustrate specific shapes, sizes, or other structures accurately or to scale.

The system 1000 may comprise one or more information processing systems 1080. In FIG. 15, one information processing system 1080 is illustrated, but any number may be provided in other examples. The information processing system 1080 may include, for example, a computer (e.g., server), a multi-node computer (e.g., high-performance compute (HPC) system), blade server, converged system, hyperconverged system, composable system, data storage system, etc.

In FIG. 15, the information processing system 1080 is shown as comprising a plurality of information processing devices 1081, but in some examples information processing system 1080 could have a single information processing device 1081 or any number of information processing devices 1081. An information processing 1081 may include, for example, a computing device (e.g., server, a sever node, a blade of a blade server, etc.), a networking device (e.g., network router, network switch, etc.), or some other electronic device which processes (e.g., receives, transmits, and/or manipulates) data.

The information processing system 1080 is a liquid cooled system, and thus comprises a system liquid cooling loop 1170 configured to circulate liquid coolant through the information processing devices 1081. The system liquid cooling loop 1170 comprises various liquid cooling infrastructure, including liquid supply lines 1171 to supply cold liquid coolant to the information processing device 1081 and liquid return lines 1172 to return warmed liquid coolant from the information processing devices 1081. The liquid cooling loop 1170 may also include a coolant distribution unit (CDU) 1090. The liquid cooling loop 1170 may also include local cooling loops inside the respective chassis of the information processing devices 1081, with each local cooling loop cooling the components of the corresponding information processing devices 1081. The local cooling loops may comprise cold plates, fluid lines, and other liquid cooling infrastructure as would be familiar to those in the art. The liquid supply lines 1171 may be fluidically coupled to the local cooling loops and to a supply (outlet) side of the CDU 1090. The liquid supply lines 1171 may be connected to the CDU 1090 via a supply manifold which splits a single flow of liquid coolant received from the CDU 1090 into multiple flows carried by the liquid supply lines 1171. Conversely, the liquid return lines 1172 may be fluidically coupled to the local cooling loops and to a return (inlet) side of the CDU 1090. The liquid return lines 1172 may be connected to the CDU 1090 via a return manifold 1086 which combines the multiple flows carried by the liquid return lines 1172 into a single flow of liquid coolant which is returned to the CDU 1090. The liquid coolant can thus flow in a loop from the outlet side of the CDU 1090, through the local cooling loops inside the information processing devices 1081, and then back to the inlet side of the CDU 109.

In addition, the CDU 1090 may comprise a heat exchanger arranged to cool the liquid coolant by transferring heat from the liquid coolant to another cooling medium, such as a facility-wide cooling medium. In this way, the liquid coolant provided by the CDU 1090 to the information processing devices 1081 can be relatively cool (thus allowing for more efficient heat removal from electronic devices), the coolant is then heated by the information processing devices 1081 and the heated liquid coolant is returned to the CDU 1090, and then the CDU 1090 cools the heated liquid coolant and supplies the now-cooled liquid coolant back to the information processing devices 1081 for another cycle. The facility-wide cooling medium that removes the heat from the liquid coolant in the CDU 1090 may be air (e.g., the CDU 1090 may comprise a liquid-to-air heat exchanger, such as a radiator) or liquid (e.g., the CDU 1090 may comprise a liquid-to-liquid heat exchanger). In FIG. 15, the CDU 1090 is shown as being configured for liquid for liquid-to-liquid heat exchange, with the CDU 1090 being coupled to facility supply line to receive facility liquid coolant into which the CDU 1090 transfers heat and being coupled to a facility return into which the CDU 1090 returns the facility liquid coolant.

The liquid cooling loop 1170 may also include one or more pumps which drive the liquid to flow in the above-described loop. In some examples, the CDU 1090 comprises one or more pumps. In some examples, local pumps are distributed among the information processing devices 1081, with each information processing device 1081 having one or more of the local pumps being disposed therein in or attached thereto. Such local pumps may be used in addition to CPU pumps or in lieu of the CDU pumps, depending on the desired implementation. In some examples, local pump modules may be provided for the information processing devices, with the local pump modules having local pumps and being either attached to or disposed within the chassis of the information processing device.

The various liquid cooling components of the liquid cooling loop 1070 may be connected together using various attachment techniques, with at least some of the connections comprising a fluid O-ring gland fitting 1100. The fittings 1100 comprise any of the fittings disclosed herein, such as the fitting 100 or the fitting 200. In FIG. 15, the fittings 1100 are shown as being used to connect each of the liquid supply lines 1171 and liquid return lines 1172 to each of the information processing devices 1081 and to the supply and return manifolds 1085 and 1086, as well as to connect liquid supply/return lines to the CDU 1090. However, this is merely one example of how the fittings 1100 could be used, and in some examples disclosed herein the fittings 1100 could be used for less than all of these couplings (at least one coupling in the liquid cooling loop 1070 uses fitting 1100). The fittings 1100 allow for the components to be easily connected and disconnected as needed, while providing excellent leak prevention due to the redundant non-radially seal pairs provided thereby.

In some examples, the fittings 1100 can also be used inside the information processing devices 1081, for example to removably connect liquid cooling component internal to the information processing devices 1081. For example, an individual information processing device 1081 may include an internal cooling loop, and in some cases this internal cooling loop can include a primary section and a removable secondary (expansion) section which can allow for cooling of expansion devices added to the information processing device, and in some examples the fittings 1100 may be used to connect the primary section to the removable secondary (expansion) section of the internal cooling loop. As another example, an individual information processing device 1081 may include a local pump module which includes one or more local pumps, and the pump module may be coupled to the internal local cooling loop of the information processing device 1081 by one or more fittings 1100. For example, one half of a fitting 1100 (e.g., plug or socket) may be attached to the pump module and the other half of the fitting 1100 (e.g., socket or plug) may be attached to the local cooling loop (in some examples, attached to the chassis). In some examples, the pump module may be removable, and the fittings 1100 may facilitate the easy plugging in and/or removing of the pump modules.

In the description above, various types of electronic circuitry are described. As used herein, "electronic" is intended to be understood broadly to include all types of circuitry utilizing electricity, including digital and analog circuitry, direct current (DC) and alternating current (AC) circuitry, and circuitry for converting electricity into another form of energy and circuitry for using electricity to perform other functions. In other words, as used herein there is no distinction between "electronic" circuitry and "electrical" circuitry.

It is to be understood that both the general description and the detailed description provide examples that are explanatory in nature and are intended to provide an understanding of the present disclosure without limiting the scope of the present disclosure. Various mechanical, compositional, structural, electronic, and operational changes may be made without departing from the scope of this description and the claims. In some instances, well-known circuits, structures, and techniques have not been shown or described in detail in order not to obscure the examples. Like numbers in two or more figures represent the same or similar elements.

In addition, the singular forms "a", "an", and "the" are intended to include the plural forms as well, unless the context indicates otherwise. Moreover, the terms "comprises", "comprising", "includes", and the like specify the presence of stated features, steps, operations, elements, and/or components but do not preclude the presence or addition of one or more other features, steps, operations, elements, components, and/or groups. Components described as coupled may be electronically or mechanically directly coupled, or they may be indirectly coupled via one or more intermediate components, unless specifically noted otherwise. Mathematical and geometric terms are not necessarily intended to be used in accordance with their strict definitions unless the context of the description indicates otherwise, because a person having ordinary skill in the art would understand that, for example, a substantially similar element that functions in a substantially similar way could easily fall within the scope of a descriptive term even though the term also has a strict definition.

And/or: Occasionally the phrase "and/or" is used herein in conjunction with a list of items. This phrase means that any combination of items in the list-from a single item to all of the items and any permutation in between-may be included. Thus, for example, "A, B, and/or C" means "one of {A}, {B}, {C}, {A, B}, {A, C}, {C, B}, and {A, C, B}".

Elements and their associated aspects that are described in detail with reference to one example may, whenever practical, be included in other examples in which they are not specifically shown or described. For example, if an element is described in detail with reference to one example and is not described with reference to a second example, the element may nevertheless be claimed as included in the second example.

Unless otherwise noted herein or implied by the context, when terms of approximation such as "substantially," "approximately," "about," "around," "roughly," and the like, are used, this should be understood as meaning that mathematical exactitude is not required and that instead a range of variation is being referred to that includes but is not strictly limited to the stated value, property, or relationship. In particular, in addition to any ranges explicitly stated herein (if any), the range of variation implied by the usage of such a term of approximation includes at least any inconsequential variations and also those variations that are typical in the relevant art for the type of item in question due to manufacturing or other tolerances. In any case, the range of variation may include at least values that are within ±1% of the stated value, property, or relationship unless indicated otherwise.

Further modifications and alternative examples will be apparent to those of ordinary skill in the art in view of the disclosure herein. For example, the devices and methods may include additional components or steps that were omitted from the diagrams and description for clarity of operation. Accordingly, this description is to be construed as illustrative only and is for the purpose of teaching those skilled in the art the general manner of carrying out the present teachings. It is to be understood that the various examples shown and described herein are to be taken as exemplary. Elements and materials, and arrangements of those elements and materials, may be substituted for those illustrated and described herein, parts and processes may be reversed, and certain features of the present teachings may be utilized independently, all as would be apparent to one skilled in the art after having the benefit of the description herein. Changes may be made in the elements described herein without departing from the scope of the present teachings and following claims.

It is to be understood that the particular examples set forth herein are nonlimiting, and modifications to structure, dimensions, materials, and methodologies may be made without departing from the scope of the present teachings.

Aspects of the present disclosure may be defined by the following clauses:
1. A fitting for a liquid cooling loop of an information processing device, comprising:
   a plug comprising a mating protrusion and a plug gland surface;
   a socket comprising a socket gland surface and a mating recess configured to receive the mating protrusion in a mated state of the plug and socket; and
   an O-ring,
   wherein the plug gland surface and socket gland surface are configured to, in the mated state, form a gland which contains the O-ring,
   wherein the plug gland surface comprises sealing surface features and the socket gland surface comprises complementary sealing surface features configured to, in the mated state, compress the O-ring therebetween and form a plurality of non-radial seal pairs, and
   wherein each of the non-radial seal pairs comprises two contact-stress surface-seals formed by one of the sealing surface features and one of the complementary sealing surface features on opposite non-radial sides of the O-ring.
2. The fitting of clause 1,
   wherein the sealing surface features of the plug gland surface comprise a face-seal surface feature and a first angular-seal surface feature, and the complementary sealing surface features of the socket gland surface comprise a complementary face-seal surface feature and a complementary first angular-seal surface feature,
   wherein the face-seal surface feature and the complementary face-seal surface feature are configured to, in the mated state, engage opposite axial sides of the O-ring to form a face seal pair, the face seal pair being one of the non-radial seal pairs, and
   wherein the first angular-seal surface feature and the complementary first angular-seal surface feature are configured to, in the mated state, engage a first pair of opposite diagonal sides of the O-ring to form a first angular seal pair, the first angular seal pair being one of the non-radial seal pairs.
3. The fitting of clause 2,
   wherein the face-seal surface feature comprises an axial protrusion from an axial face of the plug and the complementary face-seal surface feature comprises an axial protrusion from an axial face of the socket.
4. The fitting of clause 3,
   wherein, in the mated state, the face-seal surface feature is axially aligned with the complementary face-seal surface feature.
5. The fitting of clause 2,
   wherein the first angular-seal surface feature comprises a first sloped surface in an axial face of the plug and the complementary first angular-seal surface feature comprises a second sloped surface in an axial face of the socket.
6. The fitting of clause 5,
   wherein, in the mated state, the second sloped surface and the first sloped surface are sloped at a same angle relative to an axis of the fitting.
7. The fitting of clause 2,
   wherein, in the mated state, in a cross-section a line extending from the first angular-seal surface to the complementary first angular-seal surface feature is at a non-zero non-right angle relative to an axis of the fitting.
8. The fitting of clause 7,
   wherein, in the mated state, the line extending from the first angular-seal surface to the complementary first angular-seal surface feature is at an angle θ relative to the axis of the fitting, where the absolute value of θ equals 45°±15°.
9. The fitting of clause 2,
   wherein the sealing surface features of the plug gland surface comprise a second angular-seal surface feature and the complementary sealing surface features of the socket gland surface comprise a complementary second angular-seal surface feature, and
   wherein the second angular-seal surface feature and the complementary second angular-seal surface feature are configured to, in the mated state, engage a second pair of opposite diagonal sides of the O-ring to form a second angular seal pair, the second angular seal pair being one of the non-radial seal pairs.
10. The fitting of clause 1,
   wherein the sealing surface features of the plug gland surface comprise a first angular-seal surface feature and a second angular-seal surface feature, and the complementary sealing surface features of the socket gland surface comprise a complementary first angular-seal surface feature and a complementary second angular-seal surface feature,
   wherein the first angular-seal surface feature and the complementary first angular-seal surface feature are configured to, in the mated state, engage a first pair of opposite diagonal sides of the O-ring to form a first angular seal pair, the first angular seal pair being one of the non-radial seal pairs, and
   wherein the second angular-seal surface feature and the complementary second angular-seal surface feature are configured to, in the mated state, engage a second pair of opposite diagonal sides of the O-ring to form a second angular seal pair, the second angular seal pair being one of the non-radial seal pairs.
11. The fitting of clause 10,
   wherein the first angular-seal surface feature comprises a first sloped surface in an axial face of the plug and the complementary first angular-seal surface feature comprises a second sloped surface in an axial face of the socket; and
   wherein the second angular-seal surface feature comprises a third sloped surface in the axial face of the plug and the complementary second angular-seal surface feature comprises a fourth sloped surface in the axial face of the socket parallel to and facing the third sloped surface.
12. The fitting of clause 11,
   wherein, in the mated state, the second sloped surface and the first sloped surface, are sloped at a first angle relative to an axis of the fitting, and
   the fourth sloped surface and the third sloped surface are sloped at a second angle relative to the axis of the fitting.
13. The fitting of clause 1,
   wherein the plug comprises a first base portion and a first channel extending through the base portion and through the mating protrusion, the mating protrusion protruding axially from the plug, the plug gland surface comprising surfaces of the first base portion and the mating protrusion and
   wherein the socket comprises a second base portion, an axial ring, and a second channel extending through the second base portion, the matting recess comprising a portion of the second channel, the socket gland surface comprising surfaces of the axial ring and the second base portion.
14. The fitting of clause 1,
   wherein a radially outer surface of the mating protrusion comprise a tapered lead-in.
15. The fitting of clause 1,
   wherein a radially outer surface of the mating protrusion comprises an O-ring seat configured to carry the O-ring in a non-mated state of the plug and socket, and a sloped ramp configured to engage the O-ring during a mating of the plug and socket such that the O-ring slides along the sloped ramp and the sloped ramp stretches the O-ring radially outward.
16. An information processing device comprising:
   a chassis;
   a primary system board comprising one or more electronic components disposed in the chassis; and
   a liquid cooling loop disposed in the chassis and configured to circulate liquid coolant to cool the one or more electronic components, wherein the liquid cooling loop comprises the fitting of clause 1.
17. An information processing system comprising:
   a plurality of information processing devices, respectively; and
   a system liquid cooling loop configured to circulate liquid coolant to the information processing devices, wherein the system liquid cooling loop comprises:
      a coolant distribution unit comprising a heat exchanger;
      local cooling loops disposed, respectively, in chassis of the information processing devices to cool the information processing devices,
      liquid supply lines connecting a supply side of the coolant distribution unit to the local cooling loops of the information processing devices;
      liquid return lines connecting the local cooling loops of the information processing devices to a return side of the coolant distribution unit; and one or more instances of the fitting of clause 1.
18. The information processing system of clause 17,
   wherein the information processing devices include a first information processing device having a first chassis and a first local cooling loop inside the first chassis,
   wherein the system liquid cooling loop comprises a first local pump module disposed in or attached to the first chassis and comprising one or more pumps,
   wherein the one or more instances of the fitting comprise a first fitting communicably connecting the first local pump module to the first local cooling loop.
19. The information processing system of clause 17,
   wherein the one or more instances of the fitting comprise a first fitting communicably connecting one of the liquid supply lines to one of the local cooling loops.
20. The information processing system of clause 17,
   wherein the system liquid cooling loop comprises a manifold, and
   the one or more instances of the fitting comprise a first fitting communicably connecting the manifold to one of the liquid supply lines or one of the liquid return lines.

Other examples in accordance with the present disclosure will be apparent to those skilled in the art from consideration of the specification and practice of the invention disclosed herein. It is intended that the specification and examples be considered as exemplary only, with the following claims being entitled to their fullest breadth, including equivalents, under the applicable law.

## Claims

1. A fitting for a liquid cooling loop of an information processing device, comprising:
a plug comprising a mating protrusion and a plug gland surface;
a socket comprising a socket gland surface and a mating recess configured to receive the mating protrusion in a mated state of the plug and socket; and
an O-ring,
wherein the plug gland surface and socket gland surface are configured to, in the mated state, form a gland which contains the O-ring,
wherein the plug gland surface comprises sealing surface features and the socket gland surface comprises complementary sealing surface features configured to, in the mated state, compress the O-ring therebetween and form a plurality of non-radial seal pairs, and
wherein each of the non-radial seal pairs comprises two contact-stress surface-seals formed by one of the sealing surface features and one of the complementary sealing surface features on opposite non-radial sides of the O-ring.

2. The fitting of claim 1,
wherein the sealing surface features of the plug gland surface comprise a face-seal surface feature and a first angular-seal surface feature, and the complementary sealing surface features of the socket gland surface comprise a complementary face-seal surface feature and a complementary first angular-seal surface feature,
wherein the face-seal surface feature and the complementary face-seal surface feature are configured to, in the mated state, engage opposite axial sides of the O-ring to form a face seal pair, the face seal pair being one of the non-radial seal pairs, and
wherein the first angular-seal surface feature and the complementary first angular-seal surface feature are configured to, in the mated state, engage a first pair of opposite diagonal sides of the O-ring to form a first angular seal pair, the first angular seal pair being one of the non-radial seal pairs.

3. The fitting of claim 2,
wherein the face-seal surface feature comprises an axial protrusion from an axial face of the plug and the complementary face-seal surface feature comprises an axial protrusion from an axial face of the socket, wherein, in the mated state, the face-seal surface feature is optionally axially aligned with the complementary face-seal surface feature.

4. The fitting of claim 2,
wherein the first angular-seal surface feature comprises a first sloped surface in an axial face of the plug and the complementary first angular-seal surface feature comprises a second sloped surface in an axial face of the socket, wherein, in the mated state, the second sloped surface and the first sloped surface are optionally sloped at a same angle relative to an axis of the fitting.

5. The fitting of claim 2,
wherein, in the mated state, in a cross-section a line extending from the first angular-seal surface to the complementary first angular-seal surface feature is at a non-zero non-right angle relative to an axis of the fitting, wherein, in the mated state, the line extending from the first angular-seal surface to the complementary first angular-seal surface feature is optionally at an angle θ relative to the axis of the fitting, where the absolute value of θ equals 45°±15°.

6. The fitting of claim 2,
wherein the sealing surface features of the plug gland surface comprise a second angular-seal surface feature and the complementary sealing surface features of the socket gland surface comprise a complementary second angular-seal surface feature, and
wherein the second angular-seal surface feature and the complementary second angular-seal surface feature are configured to, in the mated state, engage a second pair of opposite diagonal sides of the O-ring to form a second angular seal pair, the second angular seal pair being one of the non-radial seal pairs.

7. The fitting of claim 1,
wherein the sealing surface features of the plug gland surface comprise a first angular-seal surface feature and a second angular-seal surface feature, and the complementary sealing surface features of the socket gland surface comprise a complementary first angular-seal surface feature and a complementary second angular-seal surface feature,
wherein the first angular-seal surface feature and the complementary first angular-seal surface feature are configured to, in the mated state, engage a first pair of opposite diagonal sides of the O-ring to form a first angular seal pair, the first angular seal pair being one of the non-radial seal pairs, and
wherein the second angular-seal surface feature and the complementary second angular-seal surface feature are configured to, in the mated state, engage a second pair of opposite diagonal sides of the O-ring to form a second angular seal pair, the second angular seal pair being one of the non-radial seal pairs.

8. The fitting of claim 7,
wherein the first angular-seal surface feature comprises a first sloped surface in an axial face of the plug and the complementary first angular-seal surface feature comprises a second sloped surface in an axial face of the socket; and
wherein the second angular-seal surface feature comprises a third sloped surface in the axial face of the plug and the complementary second angular-seal surface feature comprises a fourth sloped surface in the axial face of the socket parallel to and facing the third sloped surface;
wherein, in the mated state, the second sloped surface and the first sloped surface, are optionally sloped at a first angle relative to an axis of the fitting, and
the fourth sloped surface and the third sloped surface are optionally sloped at a second angle relative to the axis of the fitting.

9. The fitting of claim 1,
wherein the plug comprises a first base portion and a first channel extending through the base portion and through the mating protrusion, the mating protrusion protruding axially from the plug, the plug gland surface comprising surfaces of the first base portion and the mating protrusion and
wherein the socket comprises a second base portion, an axial ring, and a second channel extending through the second base portion, the matting recess comprising a portion of the second channel, the socket gland surface comprising surfaces of the axial ring and the second base portion.

10. The fitting of claim 1,
wherein a radially outer surface of the mating protrusion comprises an O-ring seat configured to carry the O-ring in a non-mated state of the plug and socket, and a sloped ramp configured to engage the O-ring during a mating of the plug and socket such that the O-ring slides along the sloped ramp and the sloped ramp stretches the O-ring radially outward.

11. An information processing device comprising:
a chassis;
a primary system board comprising one or more electronic components disposed in the chassis; and
a liquid cooling loop disposed in the chassis and configured to circulate liquid coolant to cool the one or more electronic components, wherein the liquid cooling loop comprises the fitting of claim 1.

12. An information processing system comprising:
a plurality of information processing devices, respectively; and
a system liquid cooling loop configured to circulate liquid coolant to the information processing devices, wherein the system liquid cooling loop comprises:
a coolant distribution unit comprising a heat exchanger;
local cooling loops disposed, respectively, in chassis of the information processing devices to cool the information processing devices,
liquid supply lines connecting a supply side of the coolant distribution unit to the local cooling loops of the information processing devices;
liquid return lines connecting the local cooling loops of the information processing devices to a return side of the coolant distribution unit; and one or more instances of the fitting of claim 1.

13. The information processing system of claim 12,
wherein the information processing devices include a first information processing device having a first chassis and a first local cooling loop inside the first chassis,
wherein the system liquid cooling loop comprises a first local pump module disposed in or attached to the first chassis and comprising one or more pumps,
wherein the one or more instances of the fitting comprise a first fitting communicably connecting the first local pump module to the first local cooling loop.

14. The information processing system of claim 13, wherein the one or more instances of the fitting comprise a first fitting communicably connecting one of the liquid supply lines to one of the local cooling loops.

15. The information processing system of claim 13, wherein the system liquid cooling loop comprises a manifold, and the one or more instances of the fitting comprise a first fitting communicably connecting the manifold to one of the liquid supply lines or one of the liquid return lines.
